Europäisches Patentamt

European Patent Office

Office européen des brevets

(11) Veröffentlichungsnummer : **0 101 782**
**B1**

(12)

# EUROPÄISCHE PATENTSCHRIFT

(45) Veröffentlichungstag der Patentschrift :
11.11.87

(51) Int. Cl.⁴ : **H 01 R    9/09**

(21) Anmeldenummer : 83100831.3

(22) Anmeldetag : 28.01.83

(54) **Kleinformatige Kontaktstift-Baugruppe.**

(30) Priorität : 30.07.82 DE 3228581

(43) Veröffentlichungstag der Anmeldung :
07.03.84 Patentblatt 84/10

(45) Bekanntmachung des Hinweises auf die Patenterteilung : 11.11.87 Patentblatt 87/46

(84) Benannte Vertragsstaaten :
DE FR GB IT

(56) Entgegenhaltungen :
DE-A- 1 936 422
DE-A- 2 228 953
DE-A- 3 006 437
DE-A- 3 120 629
US-A- 3 792 412
US-A- 3 846 741

(73) Patentinhaber : Bihler, Otto
Schleiferweg 2
D-8959 Halblech (DE)

(72) Erfinder : Bihler, Otto
Schleiferweg 2
D-8959 Halblech (DE)

(74) Vertreter : Weickmann, Heinrich, Dipl.-Ing. et al
Patentanwälte Dipl.-Ing. H.Weickmann Dipl.-Phys.Dr.
K.Fincke Dipl.-Ing. F.A.Weickmann Dipl.-Chem. B.
Huber Dr.-Ing. H. Liska Dipl.-Phys.Dr. J. Prechtel
Postfach 860820
D-8000 München 86 (DE)

## Beschreibung

Die Erfindung betrifft eine kleinformatige elektrische Kontaktstift-Baugruppe zum Eingriff mit einer insbesondere in einer Leiterplatte angeordneten Steckerbuchse von annähernd kreisrundem Querschnitt, diese Kontaktstiftbaugruppe umfassend einen Grundstift und eine an diesem Grundstift angeordnete Kontaktbiegefeder, welche an dem Grundstift abgestützt ist, leitende Verbindung mit dem Grundstift hat und zum elektrischen Kontakteingriff unter radialer Spannung mit dem Innenumfang der Steckerbuchse bemessen ist.

Eine solche Kontaktstiftbaugruppe ist aus der US-A-3 792 412 bekannt.

Wenn hier von kleinformatiger Kontaktstift-Baugruppe die Rede ist, so ist dabei insbesondere an Formate gedacht, die einem Innendurchmesser der Steckerbuchse von bis zu 2,5 mm, insbesondere ca. 1 mm, entsprechen. Die Kontaktstift-Baugruppe ist insbesondere zur elektrischen und gegebenenfalls auch mechanischen Verbindung von sog. « Chips » oder I.C.-Moduls auf Leiterplatten bestimmt. Die Steckerbuchsen sind in diesem Falle von metallisierten, insbesondere verzinnten, Löchern in den Leiterplatten gebildet. Es ist üblich, die Kontaktstifte in solche verzinnte Löcher einzustecken und dann auf der Rückseite d. h. der von dem Chip abgelegenen Seite der Leiterplatte zu verlöten. Daneben hat man auch schon versucht, die Kontaktstifte in die metallisierten Löcher einfach einzustecken und die elektrisch leitende Verbindung ohne nachträgliches Verlöten herzustellen. Die Schwierigkeit hierbei ist aber die, daß die Durchmesser dieser metallisierten Löcher schwanken, insbesondere wegen der zur Metallisierung angewandten Herstellungsverfahren, so daß eine zuverlässige Kontaktgabe, beispielsweise bei übergroßen Löchern, unsicher ist. Da aber unter Umständen sehr kleine Spannungen übertragen werden müssen, kommt es darauf an, die Kontakte mit geringem Spannungsabfall herzustellen. Um gleichwohl ohne nachträgliche Verlötung der Kontaktstifte auszukommen, hat man versucht, die Steckerstifte so zu bearbeiten, daß sie elastisch verformbar sind und sich elastisch an die Metallisierung des Lochinnenumfangs anlegen. Beispielsweise hat man den Versuch unternommen, die Kontaktstifte auf einem Teil ihrer Länge zu spalten und die durch die Spaltung gebildeten Zweige gegeneinander zu verschränken. Es hat sich jedoch gezeigt, daß die dabei entstehende Elastizität nicht ausreicht, um eine zuverlässige Kontaktgabe herzustellen. Insbesondere zeigte es sich, daß die Reibung zwischen den auch nach der Spaltung noch aneinander anliegenden Zweigen die elastische Nachgiebigkeit dieser Zweige gegeneinander beeinträchtigt hat. Es konnte deshalb passieren, daß beispielsweise bei einem durch Toleranzabweichung unterdimensionierten Loch wegen der unzureichenden elastischen Nachgiebigkeit der Kontaktstift sich soweit in die Metallisierung einarbeitete, daß die Metallisierung beiseitegeschoben wurde und der Kontaktstift an dem nichtmetallisierten Lochinnenumfang anlag, so daß die Güte der Kontaktgabe wieder in Frage gestellt war.

Bei der aus der US-A-3 792 412 bekannten Kontaktstift-Anordnung ist der Querschnitt des Grundstifts im Bereich der Anlage der Kontaktfedern quadratisch ; die Diagonalen des Quadrats sind kürzer als der Innendurchmesser der Steckerbuchse. Die beiden Kontaktfedern sind im Querschnitt senkrecht zur Längsachse des Grundstifts wellenförmig ausgebildet und liegen mit einem nach radial außen konkaven Wellental an zwei einander gegenüberliegenden Seitenflächen des Grundstifts an, während die an dieses Wellental sich anschließenden, nach radial außen konvexen Wellenberge jeder Kontaktfeder die der jeweiligen Seitenfläche des Grundstifts benachbarten Kanten des Grundstifts übergreifen. Die beiden Kontaktfedern hängen über einen den Grundstift umschließenden Verbindungsrahmen zusammen.

Bei dieser bekannten Ausführungsform ist eine unmittelbare Zentrierung des Grundstifts an der Steckerbuchse nicht möglich.

Zum Stand der Technik ist noch auf die DE-A-3 120 629 zu verweisen, die nach dem Anmeldetag der prioritätsbegründenden deutschen Patentanmeldung P 3 228 581.7, jedoch vor dem europäischen Anmeldetag veröffentlicht worden ist.

Aus dieser DE-A-3 120 629 ist eine Kontaktstiftbaugruppe nach dem Oberbegriff des Anspruchs 1 bekannt. Dabei ist nach einer ersten Ausführungsform der Querschnitt des Grundstifts auf einem Teilabschnitt von dessen Länge mit einer langen Querschnittsachse ausgeführt, deren Länge annähernd dem Innendurchmesser der Steckerbuchse entspricht, und mit einer kurzen Querschnittsachse. An den zur kurzen Querschnittsachse im wesentlichen senkrechten Seitenflächen des Grundstifts sind in Längsrichtung des Grundstifts sich erstreckende, kreissegmentartige Wülste mittig vorgesehen. Die Kontaktfedern sind im Querschnitt gewölbt und liegen mit ihrer konkaven Seite an diesen Wülsten an, so daß sie beim Einstecken in die Steckerbuchse noch stärker gewölbt werden. Die Scheitellinien der konkaven Seiten der Kontaktfedern liegen dabei an den Scheitellinien der Wülste an: Die konvexen Außenseiten der Kontaktfedern liegen mit ihren Kanten an der Innenumfangsfläche der Steckerbuchse an, so daß dort der maximale Anpreßdruck an die Steckerbuchse herrscht. Bei dieser Ausführungsform ist die schonende Behandlung der Innenumfangsfläche der Steckerbuchse nicht in vergleichbarem Maße gewährleistet wie bei der erfindungsgemäßen Ausführungsform.

Die Kontaktfedern hängen über einen Steg U-förmig zusammen und sind über diesen Steg an einem Trägerband befestigt, welches einen Magazinstreifen bildet. Die Herstellung des Magazinstreifens mit den Grundstiften und den Kontaktbiegefedern ist jedoch anders als bei dem erfindungsgemäßen Verfahren, insofern, als die Kontaktbiegefedern von dem Trägerband aus von vornherein nach einer Seite quer zur Längsrichtung des Trägerbands abstehen.

Nach einer anderen Ausführungsform der DE-A-3 120 629 ist vorgesehen, daß der Grundstift einer Rundquerschnitt besitzt, welcher von einer im Querschnitt elliptischen Kontaktfeder umschlossen ist, wobei die Ellipse im Bereich des Schnitts mit der kurzen Ellipsenachse offen ist. Bei dieser Ausführungsform ist im Gegensatz zur erfindungsgemäßen Ausführungsform eine Zentrierung des Grundstifts durch unmittelbare Anlage an der Innenumfangsfläche der Steckerbuchse nicht möglich.

Der Erfindung liegt die Aufgabe zugrunde, eine kleinformatige Kontaktstift-Baugruppe so auszubilden, daß sie an im Durchmesser variierende Kontaktbuchsen, insbesondere metallisierte Löcher von Leiterplatten, sich selbsttätig anpaßt und innerhalb der zu erwartenden Toleranzgrenzen solcher metallisierter Löcher eine gute Kontaktgabe mit entsprechend geringem Spannungsabfall liefert, auch wenn eine nachträgliche Verlötung nicht erfolgt. Eine nachträgliche Verlötung soll aber nicht ausgeschlossen sein. Weiterhin soll eine unmittelbare Zentrierung des Grundstifts an der Steckerbuchse möglich sein.

Zur Lösung dieser Aufgabe wird erfindungsgemäß vorgeschlagen, daß der Querschnitt des Grundstifts auf mindestens einem Teilabschnitt seiner Länge länglich ist mit einer langen Querschnittsachse, deren Länge annähernd dem Innendurchmesser der Steckerbuchse entspricht, und mit einer kurzen Querschnittsachse, und daß an mindestens einer zur kurzen Querschnittsachse im wesentlichen senkrechten Seitenfläche des Teilabschnitts des Grundstifts die in Längsrichtung des Grundstifts verlaufende Kontaktbiegefeder angeordnet ist, welche an dieser Seitenfläche abgestützt ist.

Die Kühnheit des Unterfangens, an einem Grundstift noch eine Kontaktbiegefeder anzubringen, wird klar, wenn man sich nochmal vergegenwärtigt, daß der Innendurchmesser der Steckerbuchse, beispielsweise eines metallisierten Lochs in einer Leiterplatte, in der Größenordnung von 1 mm liegt, beispielsweise bei 1,143 mm oder 0,889 mm ; beides sind gängige Größen in der Anschlußtechnik von Chips und dergleichen auf Leiterplatten.

Bei der erfindungsgemäßen Gestaltung kann durch den Teilabschnitt mit länglichem Querschnitt in der Richtung der langen Querschnittsachse ein Zentrierung erfolgen, während die Kontaktbiegefeder oder vorzugsweise zwei Kontaktbiegefedern elastich an dem Innenumfang der Steckerbuchse anliegt oder anliegen und einen guten elektrischen Kontakt herstellt bzw. herstellen. Die lange Achse des länglichen Querschnitts wird auf einen mittleren Durchmesser der Steckerbuchse abgestimmt, so daß die zur kurzen Querschnittsachse senkrechten Seitenflächen des Teilabschnitts bei den kleinsten vorkommenden Innendurchmessern der Steckerbuchsen in deren Metall gegebenenfalls eindringen und bei den größten vorkommenden Innendurchmessern dem Innenumfang der Metallisierung jedenfalls in so geringem Abstand gegenüberstehen, daß jedenfalls eine Zentrierung gewährleistet ist. Bei Steckerbuchsen mit kleinem Innendurchmesser kann dies dazu führen, daß die Metallisierung beiseitegedrückt wird und der Kontaktstift mit seinen zur kurzen Querschnittsachse des länglichen Querschnitts senkrechten Seitenflächen an dem unbeschichteten Material der Leiterplatte anliegt.

Bei großem Innendurchmesser der Buchsen bzw. metallisierten Löcher kann unter Umständen gar kein oder nur ein sehr schlechter Kontakt an dieser Stelle bestehen. Dies ist aber deshalb nicht von Nachteil, weil die Kontaktbiegefeder aufgrund ihrer Elastizität auf jeden Fall an dem Innenumfang der Buchse bzw. des metallisierten Lochs zur Anlage kommt, gleichgültig, ob das Loch an der unteren oder an der oberen Grenze des Toleranzbereichs liegt. Es wird also auch bei großem Innendurchmesser der Steckerbuchse ein ausreichender Kontakt hergestellt, andererseits ist es bei Durchmessern an der unteren Grenze des Toleranzbereichs nicht zu befürchten, daß das Material eines metallisierten Lochs durch die Kontaktbiegefedern beiseitegeschoben wird.

Unter Umständen ist es sogar möglich, mit erfindungsgemäß gestalteten Kontaktstift-Baugruppen Steckerbuchsen, insbesondere innen verzinnte Löcher von Leiterplatten mit unterschiedlichem Solldurchmesser von beispielsweise 1,143 mm und 0,889 mm zu bedienen.

Die Unteransprüche beinhalten wichtige Weiterbildungen der Erfindung.

Die Maßnahme des Anspruchs 2 zielt insbesondere darauf ab, die Kontaktbiegefedern so zu gestalten, daß ihre Flächenpressung zu dem Innenumfang der Steckerbuchse einerseits ausreicht, um einen guten elektrischen Kontakt zu geben, andererseits aber nicht zu groß wird, was ein Verschieben der Metallisierung zur Folge haben könnte.

Auch die Maßnahmen der Ansprüche 3 und 4 zielen darauf ab, die Metallisierung der Steckerbuchsen mit den Kontaktfedern schonend zu behandeln.

Die Maßnahme des Anspruchs 5 zielt zum einen darauf ab, eine beträchtliche elastische Nachgiebigkeit der Kontaktbiegefedern zu erzielen ; zum anderen wird durch die Maßnahme des Anspruchs 5 erreicht, daß beim Einstecken der Kontaktstiftbaugruppe in die Steckerbuchse der Kontaktdruck progressiv bis zum Erreichen der Endstellung ansteigt, was wiederum eine schonende Behandlung der Metallisierung der Steckerbuchse zur Folge hat.

Ein ausreichender Kontaktdruck ist gemäß Anspruch 6 insbesondere dann gewährleistet, wenn zumindest nach Herstellung der Steckverbindung beide Bogenenden an dem Teilabschnitt des Grundstifts in radialer Richtung abgestützt sind, trotz der äußerst minimalen Wandstärke der Blattfedern, die in der Größenordnung von 5 Hundertstel bis 20 Hundertstel mm liegen kann.

Die Maßnahme des Anspruchs 7 dient der ungehinderten Deformation der Kontaktbiegefeder unter gleichzeitiger beidendiger radialer Abstützung und unter gleichzeitiger Festlegung der Kontaktbiegefeder an dem Grundstift.

Daneben ist es durch die Maßnahme des Anspruchs 8 möglich, nach Bedarf die wirksame Federungshärte der Kontaktbiegefeder zumindest im Endbereich der Annäherung der Kontaktstift-Baugruppe an die endgültige Kontaktstellung zu erhöhen, ohne daß es dazu einer Verstärkung des Materials der Kontaktbiegefeder bedarf. Der Anspruch 9 gibt hierzu entsprechende Bemessungsvorschriften.

Zur mechanischen und elektrischen Verbindung zwischen Kontaktbiegefeder und Grundstift wird auf Anspruch 10 verwiesen.

Eine herstellungstechnisch — man denke immer wieder an die oben genannten Größenverhältnisse — besonders günstige Lösung ergibt sich aus dem Anspruch 11 ; ihr Vorteil liegt einmal darin, daß man bei Ausrüstung einer Kontaktstift-Baugruppe mit zwei Kontaktbiegefedern nicht zwei einzelne Kontaktbiegefedern handhaben und einzeln an dem Grundstift anbringen muß. Ein weiterer einschneidender Vorteil ist, daß der Anschlußteil gegebenenfalls eine Vorfixierung der Kontaktbiegefeder an dem Grundstift gestattet, bevor gegebenenfalls später noch eine Verschweißung oder eine Verlötung zur Erzielung eines besseren Übergangswiderstands angewandt wird. Dem letzteren Zwecke der Vorfixierung dient insbesondere die Maßnahme des Anspruchs 12, wobei zu bemerken ist, daß selbst dann, wenn nur eine einzige Kontaktbiegefeder zur Anwendung kommt, unter Umständen das U-förmige Anschlußteil von Vorteil im Hinblick auf die Vorfixierung ist.

Die Maßnahme des Anspruchs 13 zielt insbesondere darauf ab, den Außenumriß des fertig montierten Anschlußteils innerhalb des Innendurchmessers der Steckerbuchse zu halten.

Die Maßnahme des Anspruchs 14 zielt auf einen minimalen Übergangswiderstand zwischen Grundstift und Kontaktbiegefeder ab.

Die Maßnahme des Anspruchs 15 zielt auf eine gute Schmierung des Teilabschnitts an dem Innenumfang der Steckerbuchse ab, einmal im Hinblick auf eine möglichst exakte Zentrierung, zum anderen im Hinblick auf eine schonende Behandlung des Innenumfangs der Steckerbuchse.

Die Maßnahme des Anspruchs 16 zielt darauf ab, beim Einschieben der Kontaktstift-Baugruppe in die Steckerbuchse den mechanischen Einschubwiderstand zu erniedrigen und für den Fall, daß eine Mehrzahl von Steckern an einem Chip angeordnet sind, eine Selbstzentrierung der Steckerstifte relativ zueinander zu erreichen.

Gemäß Anspruch 17 ist es durch eine verhältnismäßig einfache Verfahrensmaßnahme möglich, aus einem im Handel erhältlichen Drahtmaterial den länglichen Querschnitt des Grundstifts in dem Teilabschnitt zu erhalten, wobei sich bei dem Flachdrücken die Krümmung der zum langen Durchmesser senkrechten Seitenflächen des Teilabschnitts durch das Verpressen selbsttätig ergibt, gegebenenfalls aber auch noch durch Gegenformen unterstützt werden kann. Mann kann grundsätzlich von runden Drahtstücken ausgehen, geht aber gemäß Anspruch 18 bevorzugt von Drahtstücken mit quadratischem Querschnitt aus, wodurch die Orientierung der Kontaktstift-Baugruppe um ihre Achse an einem Stiftträger erleichtert werden kann, wenn es beispielsweise erwünscht ist, eine Vielzahl von Kontaktstift-Baugruppen an einem Stiftträger in einer bestimmten Orientierung anzubringen.

Gemäß Anspruch 19 ergibt sich bei der Herstellung des flachgedrückten Teilabschnitts gratis der Anschlag für das eine verschiebbare Ende der Kontaktbiegefeder.

Die Maßnahme des Anspruchs 20 dient wieder dem Ziele, das Anschlußteil innerhalb des Umrisses der Steckerbuchse zu halten.

Gemäß Anspruch 21 erhält man durch die Übergangsschulter zwischen flachgedrücktem Abschnitt und unverformtem Abschnitt des Drahtes auch gleichzeitig eine Kante für die Festlegung des U-förmigen Anschlußteiles in Längsrichtung des Grundstifts.

Die Ansprüche 22 bis 25 weisen nochmals auf die besondere Kleinheit der Dimensionen der Kontaktstift-Baugruppe hin.

Es wurde überraschenderweise festgestellt, daß eine erfindungsgemäße Kontaktstift-Baugruppe trotz der außerordentlichen Kleinheit ihrer Abmessungen auf einem Stanz- und Biegeautomaten in schneller Arbeitsfolge hergestellt werden kann, wobei auf dieser Maschine sowohl das Flachdrücken der Drahtstücke, das Aufbringen der Kontaktbiegefedern und das Verschweißen der Kontaktbiegefedern mit dem Grundstift nacheinander durchgeführt werden können.

Wesentlich für die Federwirkung ist die Wölbung der Kontaktbiegefeder in der Ebene senkrecht zur Längsrichtung des Grundstifts. Es wurde festgestellt, daß man durch die Maßnahme des Anspruchs 30 höchste elastische Anpreßkräfte der Kontaktbiegefedern erhalten kann und zwar von annähernd gleicher Größe über die annähernd gesamte Länge der Kontaktbiegefedern.

Durch die Maßnahme des Anspruchs 31 wird eine weitere Erhöhung der Federkraft erzielt, weil bei dieser Ausführungsform die Endwölbungen der Badewannenwölbung noch zusätzlich zu einer Versteifung im Sinne der Erzielung erhöhter Federkräfte beitragen. Gleichzeitig haben die Badewannenendwölbungen den Vorteil, daß sie das störungsfreie Einschieben der Grundstifte in Steckerbuchsen ohne Gefahr der Beschädigung von dessen Metallisierung begünstigen.

Die Maßnahme des Anspruchs 32 sorgt dabei für eine einfache Befestigungsmöglichkeit der Kontaktbiegefedern an den zugehörigen Seitenflächen des Grundstifts.

Durch die Maßnahme des Anspruchs 33 wird die zur Kontaktgabe verfügbare Federkraft weiter erhöht, wobei die Bemessungsverhältnisse bevorzugt den Angaben der Ansprüche 34 und 35 gehorchen.

Die Maßnahme des Anspruchs 36 sorgt für ein im wesentlichen eingrabungsfreies Gleiten der Ränder der Kontaktbiegefedern auf den zugehörigen Seitenflächen der Grundstifte beim Flachpressen der Kontaktbiegefedern durch Einschieben der Grundstifte in die Steckerbuchsen. Dieses eingrabungsfreie Gleiten ist insbesondere dann erwünscht, wenn die Forderung besteht, daß der Grundstift mit seinen Kontaktbiegefedern mehrfach in eine Steckerbuchse eingeschoben werden soll können.

In diesem Falle ist es naturgemäß nicht erwünscht, wenn sich die Gleitverhältnisse der Längskanten der Kontaktbiegefedern auf den zugehörigen Seitenflächen des Grundstifts durch Eingraben verändern. Durch die Maßnahme des Anspruchs 37 wird ein solches Eingraben verhindert.

Durch die Maßnahme des Anspruchs 38, insbesondere bei Gestaltung der Seitenfläche als Dachfläche, wird das Eingraben noch zusätzlich verhindert.

Die Maßnahme des Anspruchs 39 wird insbesondere dann angewandt werden, wenn man auf ein Höchstmaß an Federkraft abstellt, weil dann die zur Verfügung stehende Federkraft durch die ungünstigen Gleitverhältnisse auf der den Kanten der Kontaktbiegefeder anliegenden Seitenfläche des Grundstifts die verfügbare Federkraft weiter erhöht wird.

Durch die Maßnahme des Anspruchs 40 kann die zur Kontaktgabe verfügbare Federkraft noch weiter erhöht werden.

Die Maßnahme des Anspruchs 41 erweist sich in Verbindung mit der Maßnahme des Anspruchs 33 nicht nur herstellungstechnisch als günstig sondern überdies auch deshalb als vorteilhaft, weil beim Flachpressen der Wölbung der Kontaktbiegefeder durch das Einführen des Grundstifts in eine Steckerbuchse die zur kurzen Querschnittsachse parallele Fläche sich in optimaler Weise an den kreisförmigen Umriß der Steckerbuchse anpaßt.

Auch die Maßnahme des Anspruchs 42 erweist sich im Hinblick auf die Erzielung einer hohen elastischen Kontaktkraft als besonders vorteilhaft. Es wurde gefunden, daß durch die Reckorientierung, die verfügbare Federkraft um ein mehrfaches erhöht werden kann, was auf eine Gefügeveränderung in dem Material der Kontaktbiegefeder zurückzuführen ist.

Es wurde gefunden, daß insbesondere dann, wenn die Grundstifte mit einem Anschlußdraht schraubenförmig umwunden werden müssen, im Hinblick auf die bei dem Umwinden nach dem sogenannten Wire-Wrap-Verfahren auftretenden Drehmomente um die Längsachse des Grundstifts größte Sorgfalt darauf angewandt werden muß, an der Stelle des Übergangs von dem Normalquerschnitt des Grundstifts zu dem flachgedrückten Querschnitt des Grundstifts Querschnittsschwächungen und Kerbwirkungen zu vermeiden, damit der Grundstift diesen Belastungen standhalten kann. Unter diesem Gesichtspunkt ist die Maßnahme des Anspruchs 43 zu verstehen.

Der Grundstift kann gemäß Anspruch 44 an mindestens einem Ende als ein Steckkontaktteil ausgebildet sein und zwar als Steckkontaktbuchse oder als Steckstift.

Im Hinblick auf die Handhabung, insbesondere bei der Bearbeitung, z. B. beim Überziehen der Grundstifte und/oder der Kontaktbiegefedern mit Edelmetallschichten erweist sich die Maßnahme des Anspruchs 45 als besonders vorteilhaft. Auch für den Einbau einer Mehrzahl von Grundstiften in einen Grundstiftaufnahmeträger ist diese Maßnahme von Bedeutung.

Eine besonders günstige Lösung im Hinblick auf die Magazinbildung ergibt sich aus dem Anspruch 46, weil das für die Herstellung der Kontaktbiegefedern ohnehin vorhandene Blechmaterial gleichzeitig zur Verbindung benachbarter Grundstifte unter Bildung eines Magazinstreifens Verwendung finden kann.

Die Maßnahme des Anspruchs 47 zielt darauf ab, bei Bedarf die Reste des Blechbandes auf einfache Weise von den Grundstiften abbrechen zu können, beispielsweise während oder nach dem Einbau in einen Grundstiftaufnahmeträger.

Die Maßnahme des Anspruchs 48 zielt auf die einfache und exakte Verarbeitung des Magazinbandes während der Bildung des Magazinbandes und bei der Weiterverarbeitung des Magazinbandes ab.

Die Maßnahme des Anspruchs 49 zeigt eine bevorzugte Ausführungsform eines Magazinbandes auf, wobei der Vorteil dieser Maßnahme insbesondere auch darin liegt, daß es möglich wird, die beiden Enden der Grundstifte von Überlagerung mit dem Trägerband freizuhalten. Dies ist insbesondere deshalb von Bedeutung, weil man beim Einbauen der Grundstifte durch Einschieben in einen Grundstiftaufnahmeträger eine freie Zugänglichkeit beider Enden der Grundstifte fordern muß, da über das außerordentlich schwache Blechbandmaterial aus dem die Kontaktbiegefedern und das Trägerband gebildet sind, keine Einschubkräfte auf die Grundstifte übertragen kann.

Dabei ist das Vorhandensein zweier Verbindungsbänder zwischen dem Trägerband und den Grundstiften für die Steifigkeit des Magazinbandes ein wesentlicher Vorteil ; die Steifigkeit wird im Hinblick auf die Handhabung des Magazinbandes bei seiner Fertigstellung und Weiterverarbeitung gefordert. Gleichwohl ist es je nach Anwendungsfall natürlich möglich auf das eine oder andere Verbindungsband zu verzichten, wobei allerdings in jedem Fall ein etwa fehlendes Verbindungsband erst dann abgenommen werden kann, wenn die Vereinigung der Kontaktfedern mit dem Grundstift beendet ist.

Die Maßnahmen der Ansprüche 50 und 51 zielen auf eine weitere Versteifung des Magazinbandes ab, sowie auf eine einfache Abbrechbarkeit der Verbindungsbänder zum gegebenen Zeitpunkt.

Die Maßnahme des Anspruchs 52 zielt wiederum auf eine Versteifung des Magazinbandes durch Versteifung des Trägerbandes ab, wobei durch die Lappen aber die Aufrollfähigkeit des Magazinbandes erhalten bleibt, die für die Lagerung der Magazinbänder zwischen aufeinanderfolgenden Bearbeitungsschritten oder vor dem Endeinsatz von Nutzen sein kann. Außerdem erleichtert das U-förmige Führungsprofil die Führung des Magazinbandes durch die bei seiner Herstellung und bei seiner Weiterverarbeitung eingesetzten Bearbeitungsmaschinen.

Die erfindungsgemäße Ausbildung der Grundstifte und Kontaktbiegefedern ist von besonderer Bedeutung bei der Bestückung von Mehrschichtleiterplatten, bei denen zwischen aufeinanderfolgenden Schichten Leiterbahnen verlaufen, die von den die Leiterbahnen durchsetzenden Löchern angeschnitten werden. Hier besteht nämlich die Situation, daß die Grundstifte auf verschiedener Höhe Kontaktkraft liefern müssen, je nach dem auf welcher Ebene die jeweilige Leiterbahn liegt. Diese Kontaktkraft kann insbesondere mit derjenigen Ausführungsform von Kontaktbiegefedern höhenunabhängig erreicht werden, bei welcher die Kontaktkraft im wesentlichen auf der Wölbung in einem Schnitt senkrecht zur Längsrichtung der Grundstifte beruht.

Wenn beispielsweise IC-Kreise oder Chips auf Leiterplatten mittels erfindungsgemäßer Kontaktstiftbaugruppen elektrisch angeschlossen und zum Teil auch mechanisch befestigt werden, so bietet dies gegenüber vorbekannten Lösungen, bei denen Chips mit ihren Anschlußfüßchen angelötet worden sind, den erheblichen Vorteil, daß einzelne Chips leicht ausgetauscht werden können, ohne daß die ganze Leiterplatte weggeworfen werden muß. Die Kontaktstift-Baugruppen sorgen auch für eine vibrationsfeste mechanische Verbindung.

Es ist auch möglich, mit Hilfe der erfindungsgemäßen Kontaktstiftbaugruppen Kombinationen von Leiterplatten miteinander zu verbinden, beispielsweise so, daß eine Gruppe von Leiterplatten senkrecht zu einer übergeordneten gemeinsamen Leiterplatte angeordnet und an dieser letzteren angeschlossen werden. In diesem Falle würden die Grundstifte an den Leiterplatten der genannten Gruppe zu diesen im wesentlichen parallel stehen und senkrecht zu der übergeordneten Leiterplatte in deren Steckerbuchsen eingeführt werden.

Die Maßnahme des Anspruchs 55 zielt auf die Reckorientierung der Kontaktbiegefedern im Wölbungsbereich ab. Dabei liefert der Anspruch 56 eine bevorzugte Arbeitsweise zu welcher folgende Überlegung geführt hat:

Es ist praktisch unmöglich, beim Wölben einzelner Kontaktbiegefedern in diese eine Reckorientierung im Sinne einer gewünschten Gefügeänderung einzubringen. Man könnte daran denken, die Reckorientierung an der vollwandigen-Blechplatte, aus welcher die Kontaktbiegefedern ausgestanzt werden, vor dem Ausstanzen durchzuführen. Auch eine solche Möglichkeit ist im Rahmen der Erfindung in Betracht gezogen. Indes würde bei dieser Ausführung das Material im Bereich der Kontaktbiegefedern durch die Streckwirkung an Dicke abnehmen. Dadurch, daß man vorher die Schlitze bildet, hat man durch entsprechende Bemessung der Klemmkraft auf die Randbereiche der Stege einerseits die Reckorientierung unter Kontrolle und andererseits die Möglichkeit die Randbereiche der Stege zwischen den Klemmwerkzeugen der Wölbung folgend nachrutschen zu lassen, so daß keine unerwünschte Wandstärkenreduzierung des Blechmaterials im Wölbungsbereich eintritt.

Der Anspruch 57 beinhaltet eine bevorzugte Verfahrensweise zur Herstellung der Kontaktstiftbaugruppen in Form von Magazinbändern, bevorzugt deshalb, weil auf der einen Seite die Ausnehmungen, die im Falle U-förmiger Anschlußstücke an den Grundstiften aus den o. a. Gründen notwendig wären, nicht benötigt werden und bevorzugt auch deshalb, weil man Magazinbänder erhält, bei denen die Grundstifte an beiden Enden frei liegen, so daß sie leicht weiterbearbeitet werden können, insbesondere auf einfache Weise mit einem Ende in Grundstiftaufnahmeträger eingeschoben werden können, in dem am jeweils anderen Ende entsprechende Einschubwerkzeuge angesetzt werden.

Die Maßnahme des Anspruchs 59 bildet die Maßnahme des Anspruchs 58 insofern weiter, als für das Abbrechen der ersten Verbindungsbänder keine besondere Maßnahme mehr erforderlich ist.

Die Ausbildung der Kontaktstiftbaugruppe nach Anspruch 54 sorgt für einen besonders widerstandsarmen elektrischen Kontakt zwischen dem Grundstift und der Kontaktfeder.

Die beiliegenden Figuren erläutern die Erfindung anhand von Ausführungsbeispielen. Es stellen dar:

Fig. 1 eine erfindungsgemäße Kontaktstift-Baugruppe, fertig montiert, in Fluchtstellung zu einer Steckerbuchse vor dem Einschieben in diese;

Fig. 2 die Teile einer Kontaktstift-Baugruppe gemäß Fig. 1 in Explosionsdarstellung vor dem Zusammenbau;

Fig. 3 eine vergrößerte Seitenansicht der Kontaktstift-Baugruppe gemäß Figuren 1 und 2, teilweise im Schnitt (Pfeilrichtung III der Fig. 1);

Fig. 4 einen Querschnitt nach Linie IV-IV der Fig. 3;

Fig. 5 einen Querschnitt nach Linie V-V der Fig. 3;

Fig. 6 eine abgewandelte Ausführungsform zu Figur 3, bei der die Kontaktbiegefedern in axialer Richtung unter Spannung gesetzt werden;

Fig. 7 eine Abwandlung des Grundstifts gemäß Fig. 2;

Fig. 8 eine weitere Abwandlung des Grundstifts gemäß Fig. 2;

Fig. 9 nochmals eine Abwandlung der Kontaktstift-Baugruppe;

Fig. 10 den Grundstift zu Fig. 9;

Fig. 11 die Blattfedern im Zustand, in dem sie aus einer Biege- und Stanzmaschine kommen;

Fig. 12 eine Einrichtung zum Flachprägen der Grundstifte;

Fig. 13 eine Einrichtung zum Einkerben der Grundstifte;

Fig. 14 einen Schnitt entlang Linie XIV-XIV der Fig. 13;

Fig. 15 eine weitere Ausführungsform einer Kontaktstiftbaugruppe, die insbesondere zum Anschluß von Drähten nach dem Wire-Wrap-Verfahren geeignet ist;

Fig. 16 einen Schnitt nach Linie XVI-XVI der Fig. 15;

Fig. 17 einen Schnitt nach Linie XVII-XVII der Fig. 15;

Fig. 18a bis 18c verschiedene Zwischenstadien bei der Herstellung einer erfindungsgemäßen Kontaktstiftbaugruppe in Form eines Magazinbandes aus einem die Kontaktbiegefedern liefernden Blechband und einzelnen Grundstiften;

Fig. 19 eine Ansicht der Kontaktstiftbaugruppe gemäß Fig. 18c in Pfeilrichtung XIX der Fig. 18c;

Fig. 20 eine Ansicht zu Fig. 19 in Pfeilrichtung XX der Fig. 19;

Fig. 21 bis 23 verschiedene Querschnittsformen von Grundstiften und Kontaktbiegefedern im Schnitt nach Linie XXI-XXI der Fig. 19;

Fig. 24 die Herstellung der Wölbungen in den Kontaktbiegefedern unter Reckorientierung in einem Ausschnitt XXIV-XXIV der Fig. 18a;

Fig. 25 eine schematische Ansicht einer Bearbeitungsmaschine zur Herstellung eines Magazinbandes erfindungsgemäßer Kontaktstiftbaugruppen aus einem die Kontaktbiegefedern liefernden Blechband und den Grundstiften;

Fig. 26 eine schematische Darstellung des Vorgangs des Einschiebens eines Magazinbandes gemäß Fig. 18c, 19 und 20 in einen Kontaktstiftaufnahmeträger;

Fig. 27 eine erfindungsgemäße Kontaktstiftbaugruppe in Verbindung mit Anschlußteilen an den beiden Enden des Grundstifts;

Fig. 28 die Anwendung erfindungsgemäßer Kontaktstiftbaugruppen zur elektrischen Verbindung eines Chips mit einer mehrschichtigen Leiterplatte und

Fig. 29 ein vergrößertes Schnittbild in einer Schnittebene entsprechend Fig. 22.

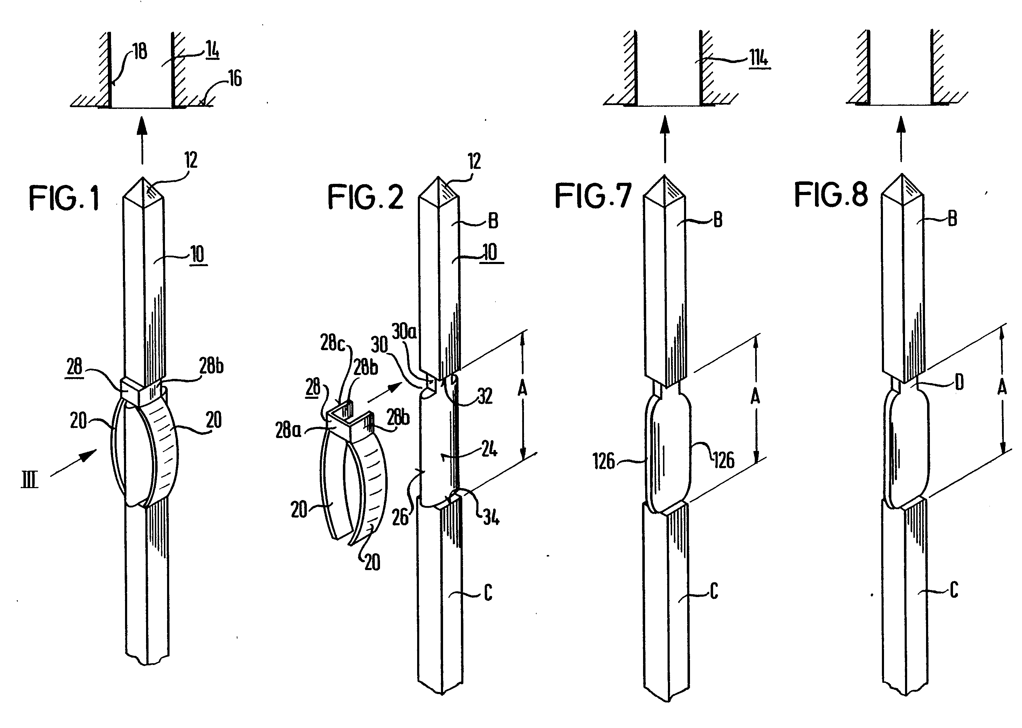

In den Fig. 1 und 2 ist ein Grundstift mit 10 bezeichnet. Das beim Einstecken vorlaufende zugespitzte Ende des Grundstifts 10 ist mit 12 bezeichnet.

Der Grundstift 10 ist zum Einstecken in eine Steckerbuchse 14 bestimmt, die beispielsweise von einem Loch einer Leiterplatte 16 gebildet ist, wobei dieses Loch an seiner Innenumfangsfläche und gegebenenfalls auch an den Randeinfassungen metallisiert ist. Die Metallisierung ist mit 18 bezeichnet.

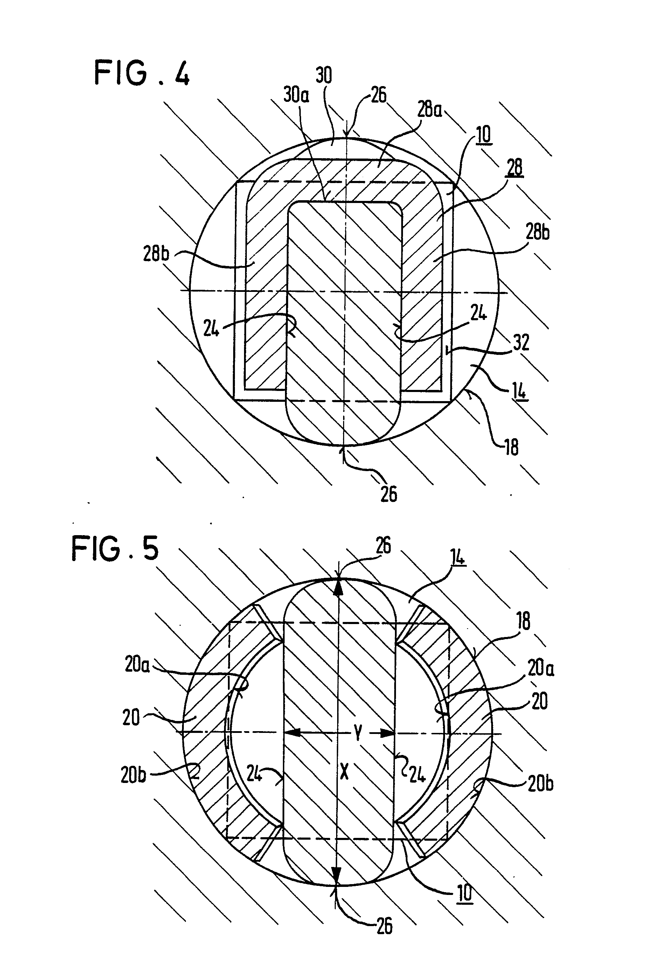

Der Grundstift 10 hat quadratischen Querschnitt. Die Querschnittsdiagonale entspricht annähernd dem Durchmesser der Steckerbuchse 14. An dem Grundstift 10 sind zwei Kontaktbiegefedern 20 und 22 im Bereich eines Teilabschnitts A der Länge des Grundstifts 10 angeordnet. Der Grundstift 10 ist, wie insbesondere auf Fig. 2 zu ersehen, im Bereich des Teilabschnitts A flachgedrückt. Der flachgedrückte Querschnitt ist insbesondere aus Fig. 5 zu ersehen. Der flachgedrückte längliche Querschnitt im Teilabschnitt A weist gemäß Fig. 5 eine lange Achse X und eine kurze Achse Y auf. Das Längenverhältnis der langen Achse X zur kurzen Achse Y beträgt ca. 3 : 1. Im Bereich des Längsabschnitts A besitzt der Grundstift 10 zwei zur kurzen Achse Y senkrechte Seitenflächen 24 und zwei zur langen Achse X senkrechte Seitenflächen 26. Die Seitenflächen 26 sind zur Innenumfangsfläche der Steckerbuchse 14 hin konvex gerundet. Die lange Achse X des länglichen Querschnitts entspricht dem Durchmesser der Steckerbuchse 14. An den Seitenflächen 24 sind die beiden Kontaktfedern 20 angeordnet. Wie aus Figur 5 ersichtlich, sind die Blattfedern 20 im Querschnitt gewölbt, so daß sie mit ihren konkaven Seitenflächen 20a den Seitenflächen 24 zugekehrt sind und mit ihren konvexen Seitenflächen 20b der Innenumfangsfläche der Steckerbuchse 14.

Die Achsen X und Y des länglichen Querschnitts des Teilabschnitts A fallen, wie aus Fig. 5 ersichtlich, mit den Achsen des quadratischen Querschnitts des Grundstifts 10 zusammen.

Die Blattfedern 20 hängen einteilig zusammen mit einem U-förmigen Anschlußteil 28, welches einen Steg 28a und zwei Schenkel 28b aufweist. Die Schenkel 28b gehen nach unten in die Blattfedern 20 über.

Der Steg 28a ist zur Anlage am Grund 30a einer Kerbe 30 bestimmt, die in einem Endabschnitt des Teilabschnitts A gebildet ist. Die Schenkel 28b sind zur Anlage an den Seitenflächen 24 ausgebildet.

Wie aus Figur 4 ersichtlich, liegt der quadratische Querschnitt des Grundstifts 10 mit seinen Ecken annähernd auf dem Innenumfang der Steckerbuchse 14. Das U-förmige Anschlußstück 28 liegt innerhalb dieses Innenumfangs. Am Übergang von dem Teilabschnitt A des Grundstifts zu dem oberen Endabschnitt B sind Übergangsschultern 32 gebildet, an denen die Kanten 28c der Schenkel 28b anliegen. Die Schenkel 28b und/oder der Steg 28a sind mit dem Grundstift verschweißt.

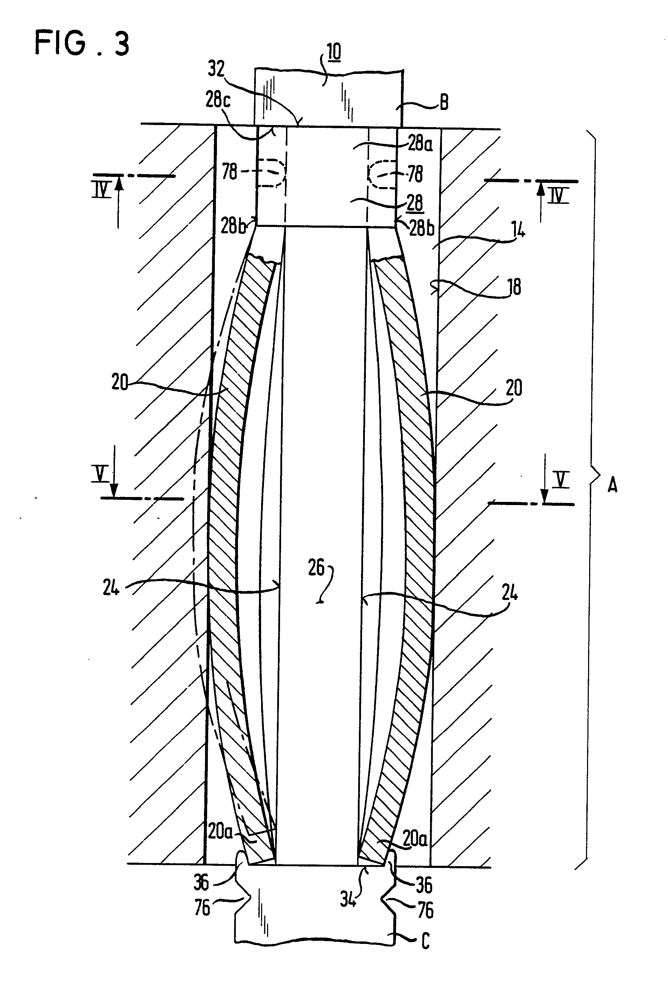

Aus Fig. 3 erkennt man die bogenförmige Krümmung der Blattfedern 20. Die unteren Enden 20a der Blattfedern 20 liegen an den Seitenflächen 24 des Abschnitts A an.

Die strichpunktierte Linie in Fig. 3 zeigt die entspannte Form einer Blattfeder 20 vor dem Einstecken in die Steckerbuchse 14. Man erkennt, daß beim Einstecken infolge der dann eintretenden im wesentlichen elastischen Flachbiegung der Blattfedern 20 diese mit ihren unteren Enden 20a auf den Seitenflächen 24 verschoben werden, bis sie an Anschlagflächen 34 des Grundstifts 10 zur Anlage kommen. Die Anschlagflächen 34 sind von Übergangsschultern zwischen dem Teilabschnitt A und dem unteren Teilabschnitt C gebildet. Angrenzend an diese Anschlagflächen 34 sind durch Verstemmung des Grundstifts im Bereich des Abschnitts C Nasen 36 gebildet, hinter welche die Enden 20a der Blattfeder 20 zumindest dann einfassen, wenn die Kontaktstift-Baugruppe vollständig in die Steckerbuchse 14 eingeschoben ist. Durch den Anschlag der Enden 20a an den Anschlagflächen 34 erhöht sich der Widerstand der Blattfedern 20 gegen radiales Zusammendrücken beträchtlich, so daß ein ausreichender Kontaktdruck zwischen den Blattfedern 20 und der Innenumfangsfläche der Steckerbuchse 14 gewährleistet ist.

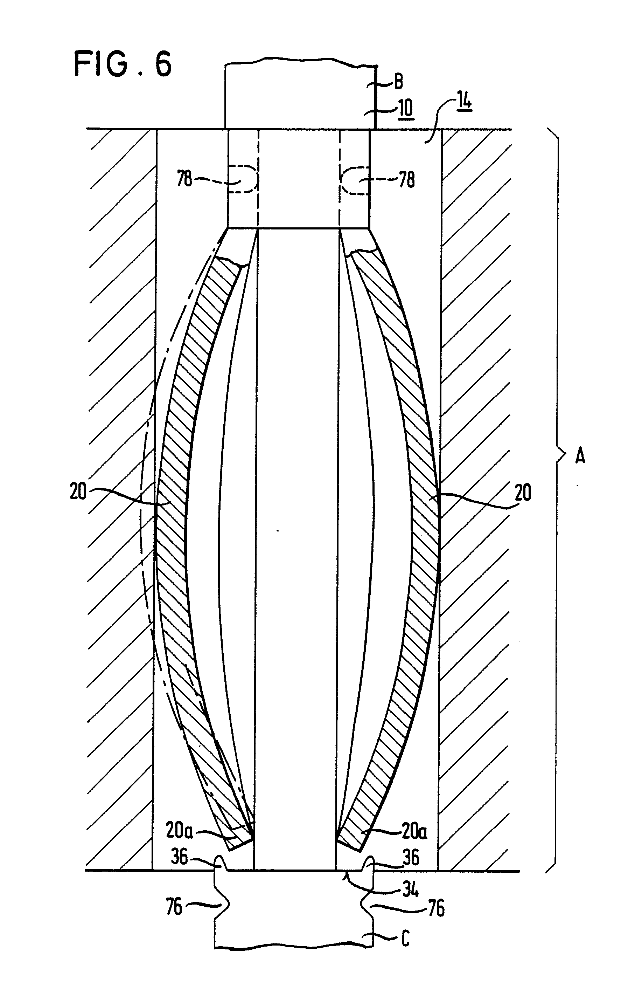

Wie aus Fig. 6 ersichtlich, ist es aber nicht unbedingt notwendig, daß die Enden 20a der Blattfedern 20 bis an die Anschlagflächen 34 herantreten, da auch durch die elastische Biegeverformung der axial nicht eingespannten Blattfedern 20 ein ausreichender Kontaktdruck gewährleistet sein kann. Im übrigen entspricht die Ausführungsform gemäß Fig. 6 derjenigen gemäß Fig. 3.

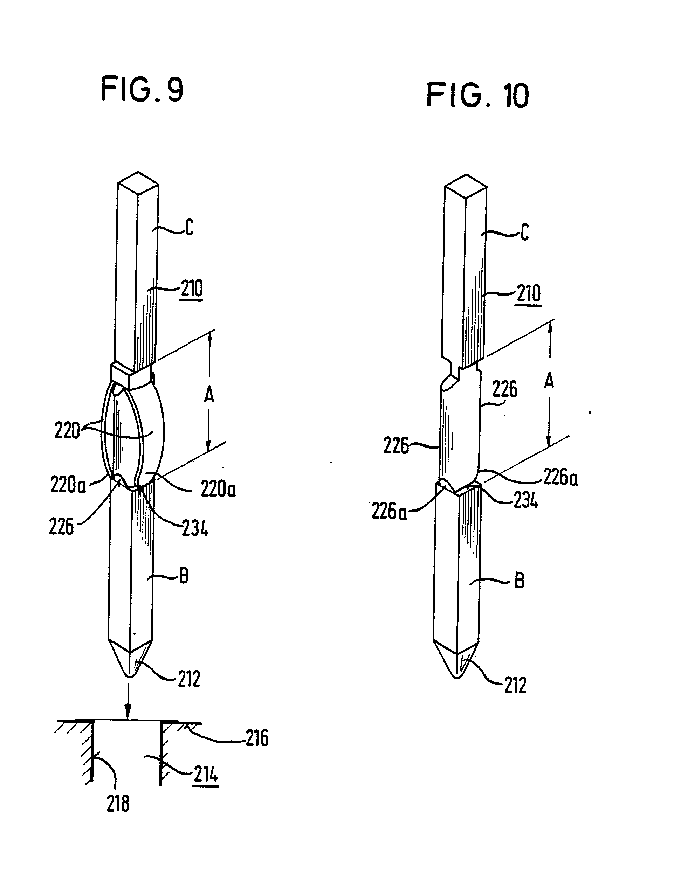

Die Ausführungsform gemäß Fig. 7 unterscheidet sich von der Ausführungsform des Grundstifts gemäß Fig. 2 dadurch, daß die Seitenflächen 126 des Teilabschnitts A an ihrem oberen (und auch an ihrem unteren) Ende in der durch den Pfeil angedeuteten Einsteckrichtung konvergieren, so daß sie beim Einstecken glatt über den Rand der Steckerbuchse 114 hinübergleiten können.

Die Ausführungsform gemäß Fig. 8 schließlich unterscheidet sich von der Ausführungsform gemäß Fig. 2 lediglich dadurch, daß auf die Kerbe 30 verzichtet ist. In dem Übergangsabschnitt D entspricht die lange Achse des Querschnitts einer Querschnittsachse des quadratischen Querschnitts des anschließenden Abschnitts B.

In sämtlichen Fällen gemäß Figuren 2, 7 und 8 kann der Teilabschnitt A durch Flachdrücken zwischen entsprechenden Prägestempeln gebildet sein.

Die Blattfedern 20 können beispielsweise aus Phosphorbronze hergestellt sein.

Wie aus Fig. 3 ersichtlich, entspricht die Länge des Teilabschnitts A annähernd dem dreifachen Innendurchmesser der Steckerbuchse 14 gemäß Fig. 5.

Der Innendurchmesser der Steckerbuchse beträgt ca. 1 mm. Die Wandstärke der Blattfedern beträgt ca. 10/100 mm.

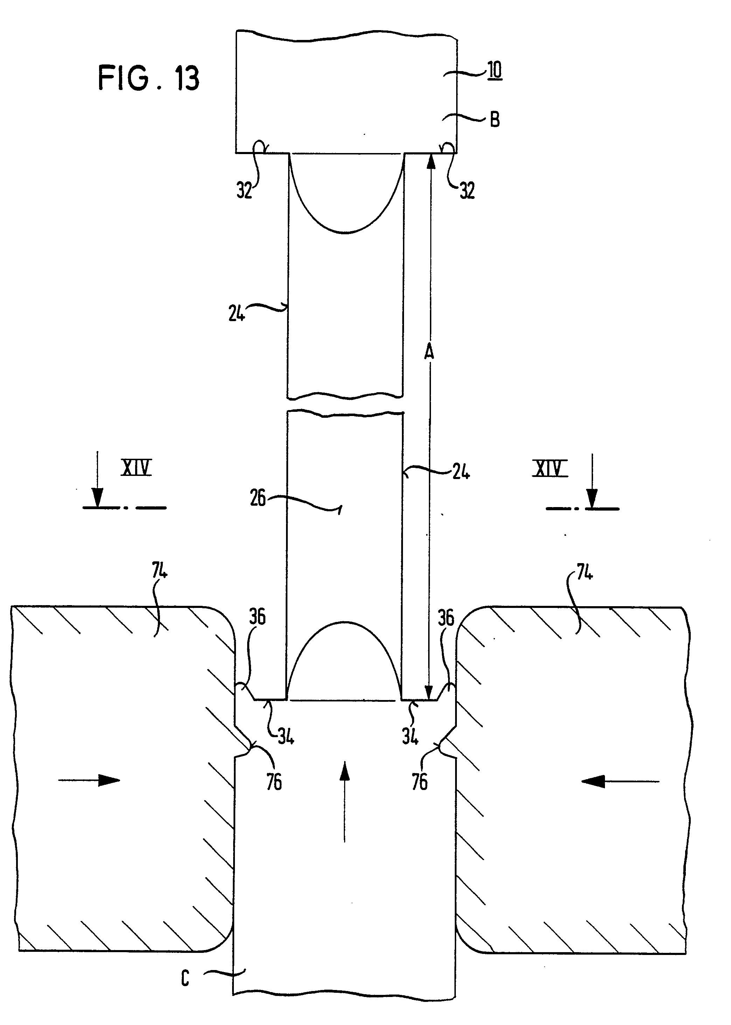

Die Ausführungsform gemäß den Figuren 9 und 10 unterscheidet sich von derjenigen nach den Figuren 1, 2, 7 und 8 dadurch, daß die Einsteckrichtung umgekehrt ist, d. h. daß die freien Enden 220a der Blattfedern 220 in Einsteckrichtung vorlaufen. Auch bei dieser Ausführungsform können sich bei radialem Druck auf die Blattfedern 220 diese in Längsrichtung des Teilabschnitts A verschieben, und zwar zu Anschlagflächen 234 hin. Um ein Verfangen der Blattfederspitzen 220a am Eingang der Steckerbuchse 214 auszuschließen, sind die in Einsteckrichtung vorlaufenden Spitzen 220a der Blattfedern 220 gerundet oder zugespitzt, wie aus Fig. 9 und 13 ersichtlich. Ein Verfangen der vorlaufenden Spitzen 220a wird im übrigen auch dadurch vermieden, daß, ähnlich wie in Fig. 3, diese Spitzen hinter Nasen liegen, die in Figuren 9 und 10 nicht eingezeichnet sind. Die Seitenflächen 226 des Teilabschnitts A sind an den beim Einstecken vorlaufenden Enden, wie bei 226a angedeutet, in Einsteckrichtung konisch ausgebildet, wodurch das Einschieben der Kontaktstift-Baugruppe in die Steckerbuchse 214 erleichtert und ein Verfangen am Eingang der Steckerbuchse vermieden wird.

Der Grundstift 210 besteht bevorzugt aus Messing oder Bronze. Die Blattfedern 220 bestehen aus Phosphorbronze oder Berylliumkupfer.

Die Federcharakteristik kann auch bei dieser Ausführungsform durch den Anschlag der Federspitzen 220a an den Anschlagflächen 234 beeinflußt werden im Sinne einer grösseren Federungshärte.

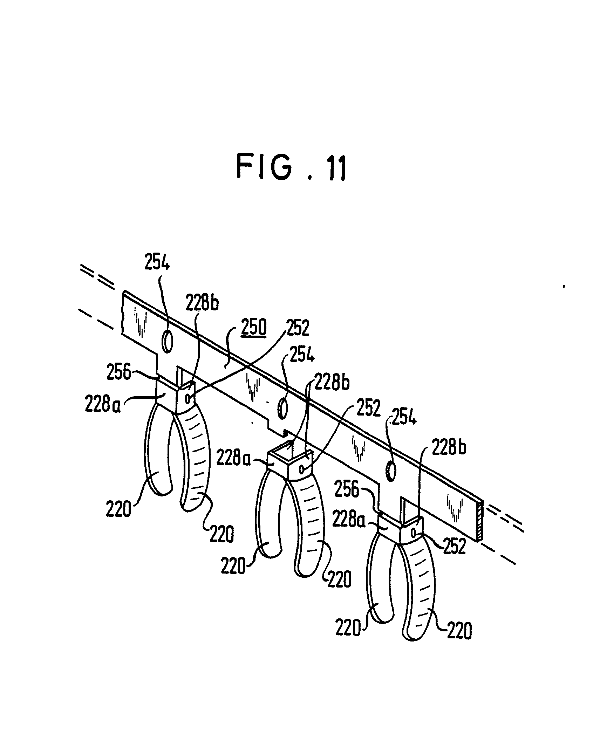

Figur 11 zeigt die Blattfeder-Baugruppen, wie sie aus einer Stanz- und Biegemaschine kommen. Man erkennt, daß aufeinanderfolgende Blattfeder-Baugruppen mit einem Verbindungsstreifen 250 zusammenhängen; dieser Verbindungsstreifen 250 liegt in einer Ebene mit den Stegen 228a. Der Verbindungsstreifen 250 ist der Rest eines Metallbands, aus dem die Blattfedern 220 ausgestanzt worden sind. Die Schenkel 228b und die Blattfedern 220 sind durch Biegen in die in Figur 11 gezeigte Form gebracht worden. An dem Schenkel 228b sind Einprägungen 252 angebracht, die das Verschweißen der Schenkel mit dem Grundstift 210 durch elektrische Übergangsschweißung erleichtern. In dem Verbindungsstreifen 250 sind Transport- und/oder Positionierungslöcher 254 angebracht, welche die Positionierung der einzelnen Kontaktfeder-Baugruppen gegenüber den jeweils zugehörigen Grundstiften in einer Montageeinrichtung erleichtern. Es ist möglich, das Stanzen und Biegen der Blattfeder-Baugruppen gemäß Fig. 11, das Formen der Grundstifte gemäß Figuren 9 und 10 und die Montage der Blattfeder-Baugruppen auf den Grundstiften in einer einzigen Maschine durchzuführen.

Um in der Montagestation die Blattfeder-Baugruppen leicht von dem Verbindungsstreifen 250 abtrennen zu können, ist an den Stegen 228a eine Bruchlinie 256 vorgebildet.

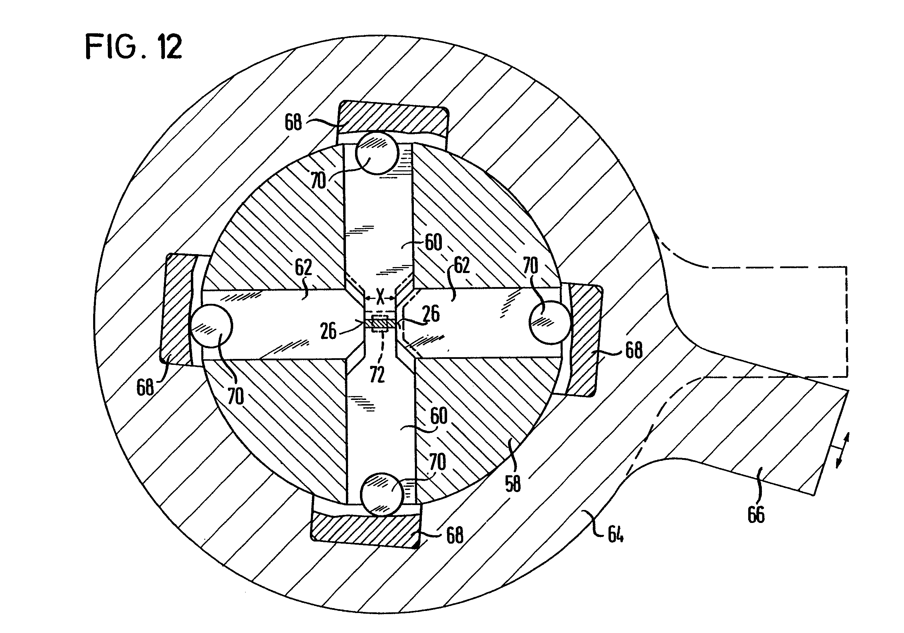

In Fig. 12 erkennt man im Schnitt eine Einrichtung zum Herstellen der Grundstifte aus einem Draht mit Quadratquerschnitt von beispielsweise 0,62 mm Seitenlänge.

In einem Werkzeugführungskern 58 sind Prägestempel 60 und Gegenhaltestempel 62 in Radialkanälen geführt. Zum Antrieb dieser Präge- und Gegenhaltestempel 60 und 62 ist der Werkzeugführungskern 58 von einem Steuerring 64 umschlossen, dessen Antriebshebel 66 mit einer Antriebseinrichtung verbunden ist. An dem Innenumfang des Steuerrings 64 sind Steuereinsätze 68 angebracht, welche mittels Übertragungswalzen 70 auf die Präge- und Gegenhaltestempel 60, 62 einwirken.

Es wird ein im Querschnitt quadratischer Draht 72 senkrecht zur Zeichenebene der Fig. 12 zugeführt. Sobald dieser Draht die Prägeposition erreicht hat, werden zunächst die Gegenhaltestempel 62 aus der gestrichelt gezeichneten Rückzugsposition in die mit ausgezogenen Linien gezeichneten Gegenhalteposition gebracht, in der ihr Abstand voneinander der langen Achse X des länglichen Querschnitts entspricht. Dann werden die Prägestempel 60 aus ihrer zurückgezogenen gestrichelt eingezeichneten Stellung vorgefahren, bis der Quadratquerschnitt des Drahts 72 zu dem länglichen Querschnitt flachgeprägt ist. Dabei tritt ganz von selbst die Rundung der Seitenflächen 26 ein. Gegebenenfalls kann die Bildung dieser Rundung noch durch entsprechende Gegenhalteflächen an der Gegenhaltestempeln 62 unterstützt werden.

Die Präge- und Gegenhaltestempel können entweder durch weitere Kurvenelemente oder durch Rückstellfedern zurückgesteuert werden.

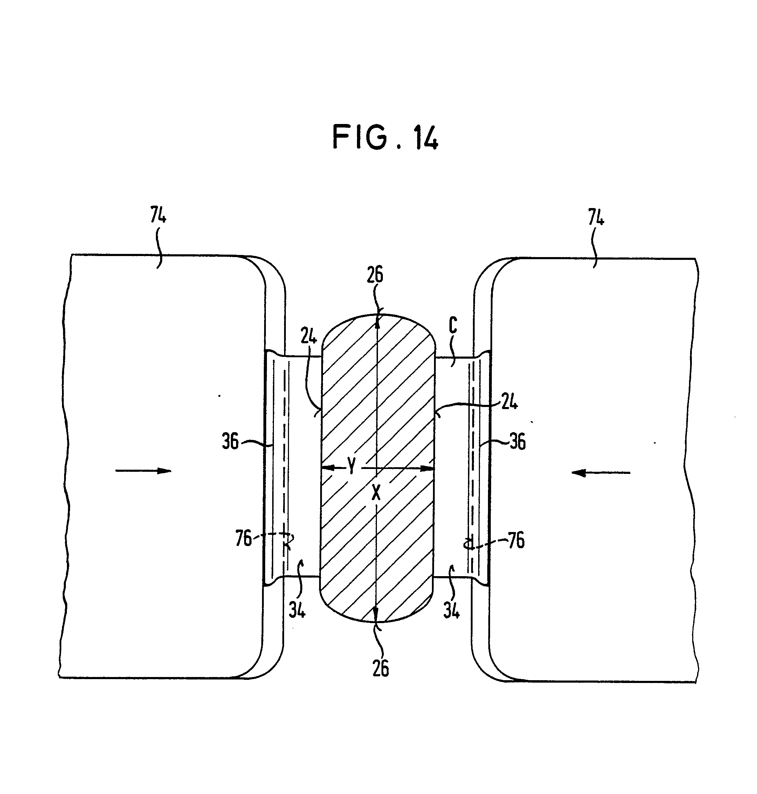

Die Figuren 13 und 14 zeigen den Arbeitsgang zur Bildung der Nasen 36 mit Hilfe von Kerbstempeln 74. Nach Bildung der Nasen 36 ist nicht nur das Einführen der Kontaktstift-Baugruppe in die Steckerbuchse erleichtert sondern überdies ein Abheben der freien Blattfederenden 20a verhindert ; diesem kommt besondere Bedeutung dann zu, wenn die Kontaktstift-Baugruppe mit den freien Federenden 20 voraus in die Steckerbuchse eingeschoben wird.

Die Kerbstempel 74 erzeugen die Nasen 36, indem sie Kerben 76 in den Abschnitt C einprägen, wobei gleichzeitig das Material in Fig. 13 nach oben verschoben wird unter Bildung der Nasen 36.

Wie schon gesagt, sind die erfindungsgemäßen Kontaktstift-Baugruppen insbesondere zum Einstecken in Leiterplatten bestimmt, die meistens aus Epoxyharz bestehen. Auf diesen Leiterplatten verlaufen die Leiterbahnen in einem bestimmten Raster. Die Anschlußstellen der Leiterbahnen sind durch die innen verzinnten Löcher gebildet, welche an ihrem Rand in die Leiterbahnen übergehen. In diese Löcher wird die erfindungsgemäße Kontaktstift-Baugruppe eingesteckt.

Die mechanische Zentrierung durch die der langen Achse X zugekehrten Seitenflächen gewährleistet den exakten Sitz der Chips gegenüber den Leiterplatten.

Selbst wenn durch diese Seitenflächen Zinn ausgeräumt wird, stellen die Blattfedern auch bei Vibration einen ständigen, guten Kontakt zur Leiterplatte her, wobei davon auszugehen ist, daß die Blattfedern, selbst wenn sie beim Einstecken teilweise plastisch verformt werden. noch mit Vorspannung an der verzinnten Innenumfangsfläche der Löcher in der Leiterplatte anliegen. Die Schrägen bei 226a in Fig. 10 verhindern überdies das Abstreifen des Zinns auch in demjenigen Bereich der verzinnten Löcher, in dem die Seitenflächen 226 zur Anlage kommen, so daß regelmäßig auch im Bereich der Seitenflächen 226a mit einer elektrischen Verbindung gerechnet werden kann, obwohl diese im Hinblick auf den großflächigen und elastischen Kontakt der Blattfedern 220 mit den verzinnten Innenumfangsflächen der Löcher grundsätzlich nicht notwendig ist.

Das Herstellungsverfahren mit der Einrichtung gemäß Fig. 12 erlaubt eine rasche Herstellung der Grundstifte in Massenfertigung. Gleichwohl wird die erforderliche Präzision durch die exakte Werkzeugbewegung gewährleistet ; Werkzeugdehnungen sind nicht möglich, da alle Bewegungsabläufe innerhalb des Steuerrings 64 stattfinden. Die Kraftübertragung über die Walzen 70 sorgt für die Ausschaltung jeglichen Spiels.

Der Streifen 250 gemäß Fig. 11 erleichtert die Montage.

In Fig. 3 sind die Schweißstellen bei 78 angedeutet.

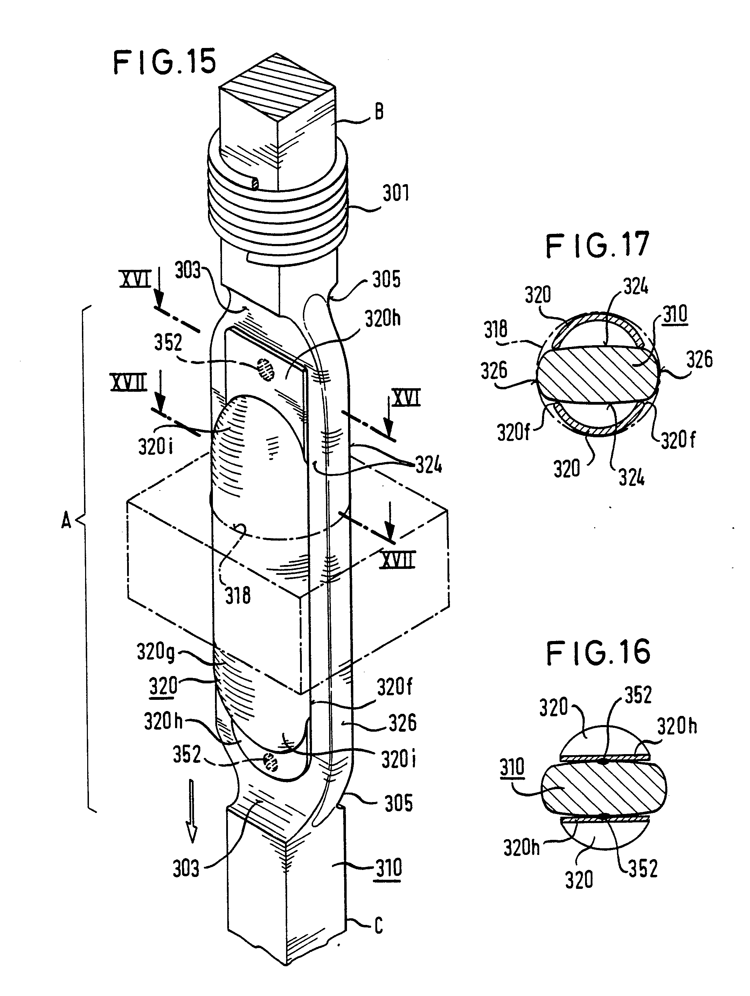

In Fig. 15 ist eine weitere Ausführungsform einer Kontaktstiftbaugruppe dargestellt ; analoge Teile sind mit gleichen Bezugszeichen versehen wie in der Ausführungsform nach den Fig. 1 bis 6, jeweils vermehrt um die Zahl 300.

In dieser Ausführungsform sind die Kontaktbiegefedern 320 mit einer badewannenförmigen Wölbung 320g ausgeführt, deren Längsrandbereiche 320f an den Seitenflächen 324 anliegen. An den Enden der badewannenförmigen Wölbung 320 sind Endflansche 320h angebracht, die durch Punktschweißstellen 352 auf den Seitenflächen 324 befestigt sind. Mit den badewannenförmigen Wölbungen 320g können große elastische Kontaktkräfte auf die Steckbuchse 318 übertragen werden.

Zu beachten ist, daß der obere Abschnitt B des Grundstifts mit einem Drahtanschluß 301 nach dem Wire-Wrap-Verfahren verbunden ist. Im Hinblick auf die beim Anbringen der Drahtwindungen 301 auftretenden Torsionskräfte auf den Grundstift C sind die Übergänge 303 und 305 der Seitenflächen 324 bzw. 326 möglichst stetig ausgeführt.

Es ist nicht unbedingt erforderlich, die Kontaktbiegefedern 320 an beiden Enden festzuschweißen. Im Hinblick auf einen Längenausgleich bei der Zusammenpressung der Kontaktbiegefedern 320 ist es denkbar, jeweils nur an einem Ende eine Schweißpunktstelle vorzusehen. Wie ohne weiteres ersichtlich, sind die Endwölbungen 320i so ausgeführt, daß sie leicht in die Steckbuchse 318 hineinfinden können. Auch die Rundung des unteren Endflansches 320h kann die Einführung in die Steckbuchse 318 begünstigen.

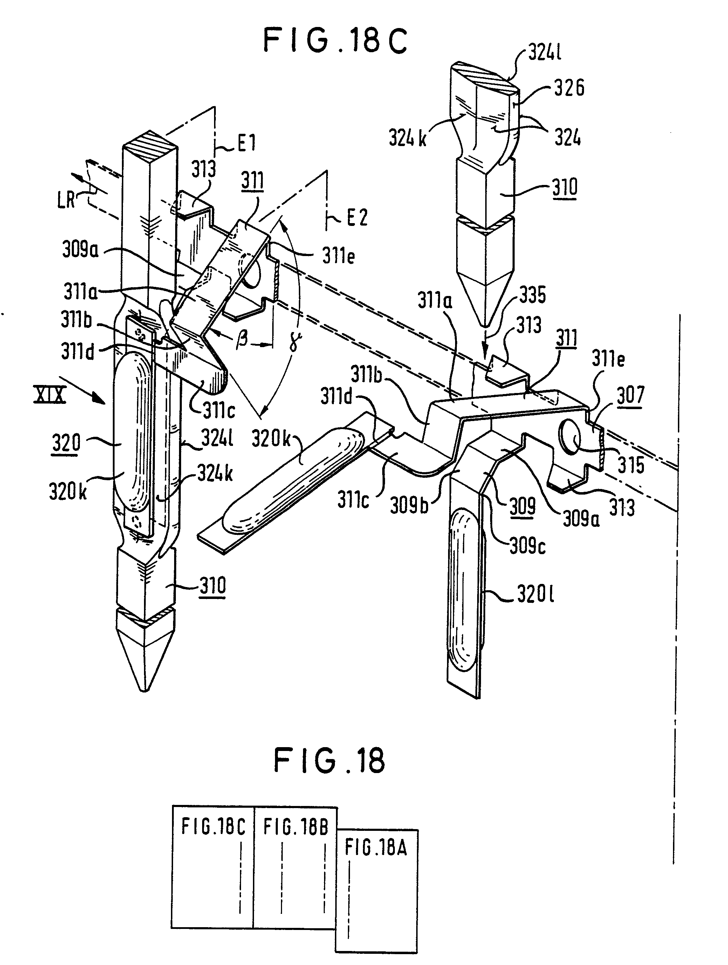

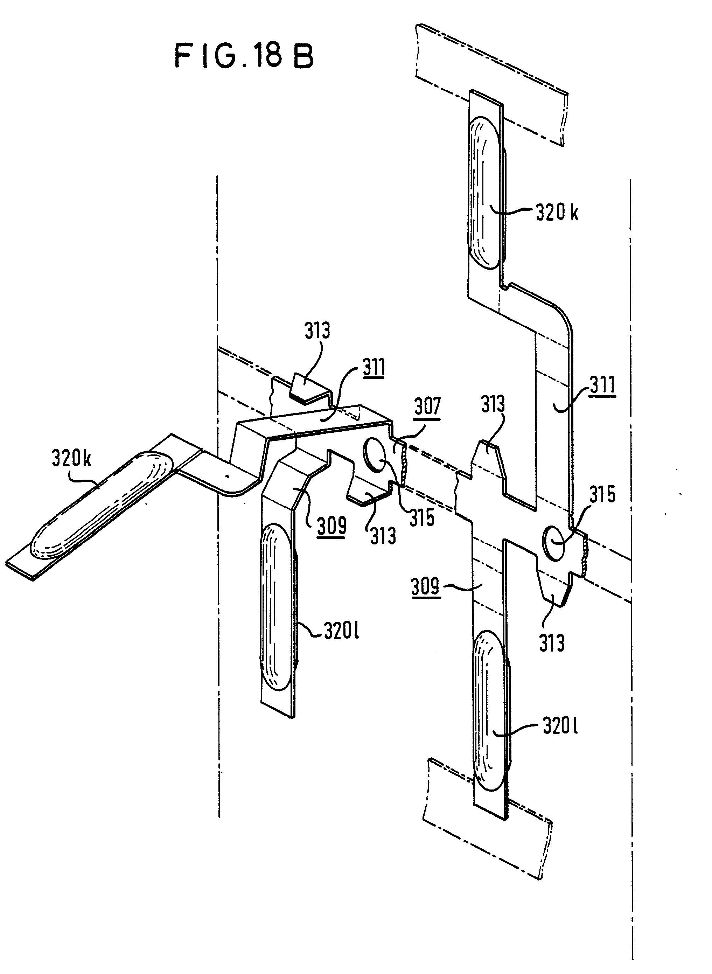

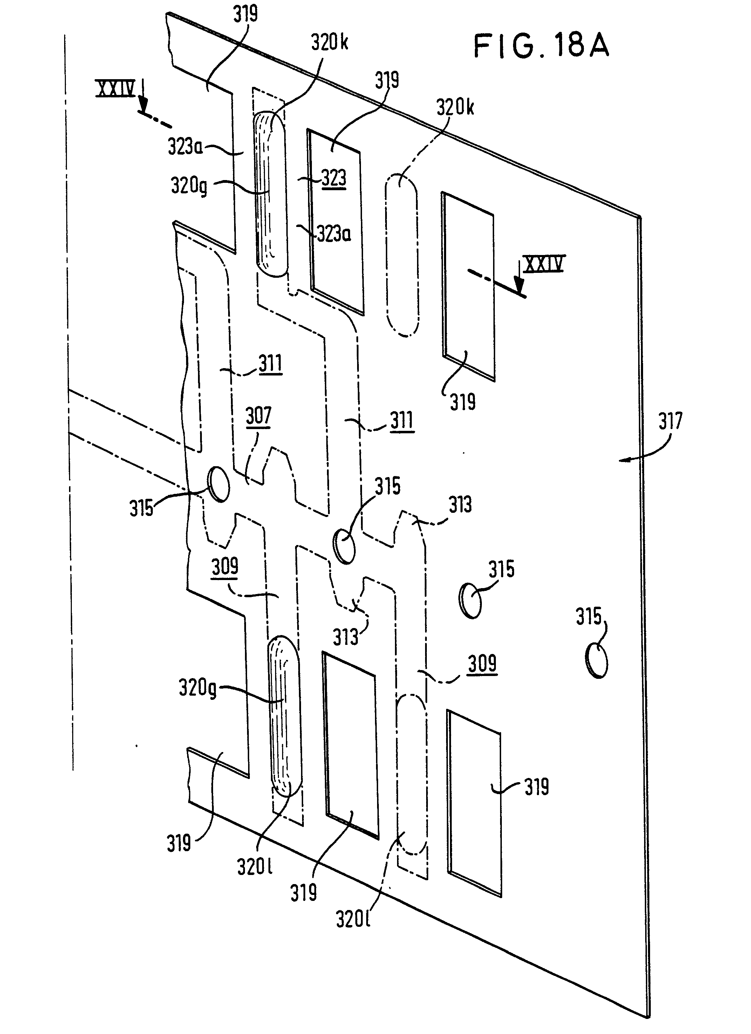

In der Fig. 18c, die einen Ausschnitt aus dem Fortlaufbild der Fig. 18 ist, erkennt man am linken Ende eine Kontaktstiftbaugruppe gemäß Fig. 15 wieder. Zwei aufeinanderfolgende Grundstifte 310 sind in Fig. 18c durch ein Trägerband 307 miteinander verbunden. Das Trägerband 307 ist einstückig mit den Kontaktbiegefedern 320, die in der Fig. 18c für die Vorderseite mit 320k und für die Rückseite der Grundstifte mit 320l bezeichnet sind ; entsprechend sind die Seitenflächen 324 der Vorderseite mit 324k und der Rückseite mit 324l bezeichnet. Die Kontaktbiegefeder 320l ist mit dem Trägerband 307 über ein erstes Verbindungsband 309 verbunden, das aus einem ersten Bandabschnitt 309a und einem zweiten Bandabschnitt 309b besteht. Die Ebene des Trägerbandes 307 ist parallel zur Längsachse des Grundstifts 310. Der erste Bandabschnitt 309a erstreckt sich im fertiggebogenen Zustand gemäß der linken Darstellung der Fig. 18d senkrecht zur Längsrichtung des Grundstifts 310 während der zweite Bandabschnitt 309b gegen die Längsrichtung des Grundstifts 310 geneigt ist. Zwischen der Kontaktbiegefeder 320l und dem zweiten Bandabschnitt 309b ist eine Sollbruchstelle 309c vorgesehen. Das erste Verbindungsband 309 liegt in einer zu dem Trägerband 307 senkrechten Ebene E1.

Die Kontaktbiegefeder 320k ist mit dem Trägerband 307 durch ein zweites Verbindungsband 311 verbunden. Dieses Verbindungsband 311 besteht aus einem mehrfach abgewinkelten Bandabschnitt 311a, b und einem Fortsetzungsband 311c. Der abgewinkelte Bandabschnitt 311a, b setzt an das Trägerband 307 an und liegt in einer Ebene E2, die gegenüber der Ebene E1 in Längsrichtung des Trägerbands 307 versetzt ist und seitlich neben dem Grundstift 310 liegt. Der Fortsetzungsbandabschnitt 311c liegt im wesentlichen parallel zur Laufrichtung LR des Trägerbands 307 und schließt einerseits an das abgewinkelte Band 311a, b und andererseits an die Kontaktbiegefeder 320k an. Sollbruchstellen sind bei 311d und 311e vorgesehen. Der Teilabschnitt 311a schließt mit der Ebene des Trägerbands 307 einen spitzen Winkel β ein. Der Teilabschnitt 311b schließt mit dem Teilabschnitt 311a im fertiggebogenen Zustand gemäß der linken Hälfte der Fig. 18c einen Winkel γ ein. Der Teilabschnitt 311a läuft von dem Trägerband 307 kommend über die Seitenfläche 324k nach vorne hinaus und der Teilabschnitt 311b läuft dann vom Ende des Teilabschnitts 311a bis in die Ebene der Seitenfläche 324k zurück.

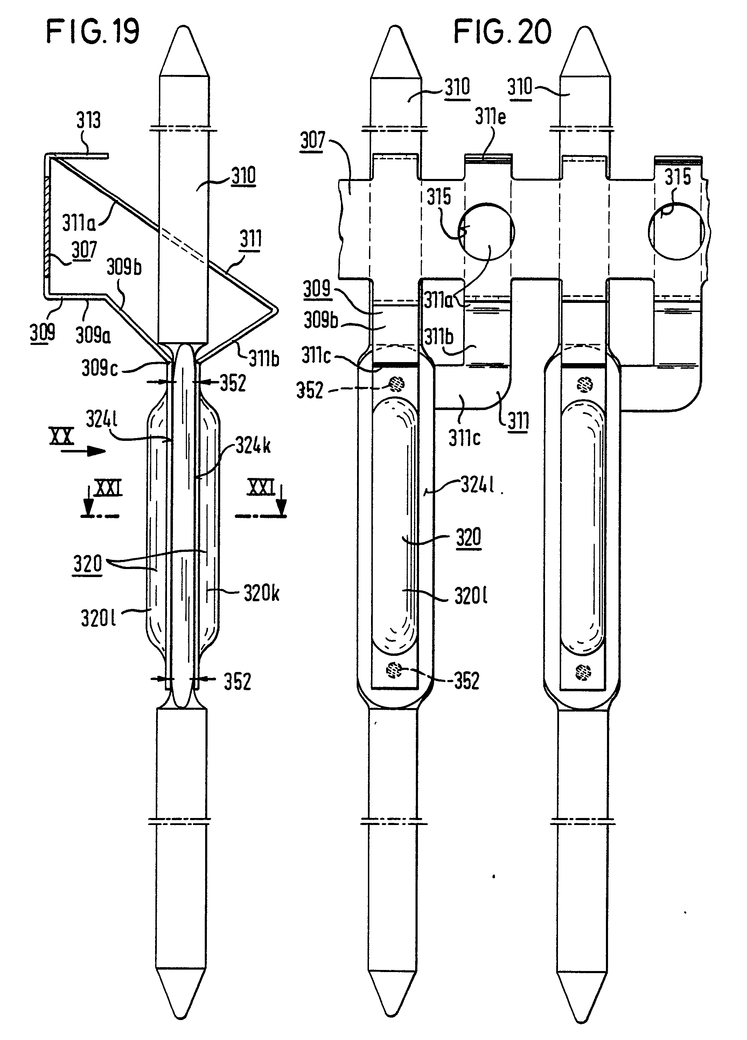

An dem Trägerband 307 sind Lappen 313 angesetzt, die zusammen mit dem Trägerband 307 ein U-Profil ergeben, wie insbesondere aus Fig. 19 zu ersehen.

Fig. 20 zeigt eine Ansicht des fertigen Magazinbandes. Fig. 19 zeigt die steife Verbindung der Kontaktstifte 310 mit dem Trägerband 307 durch die beiden Verbindungsbänder 309 und 311. Fig. 18b und 20 lassen ferner sogenannte Pilotlöcher 315 in dem Trägerband 307 erkennen. Diese Pilotlöcher dienen der Fortschaltung des Trägerbandes in einer Bearbeitungsmaschine.

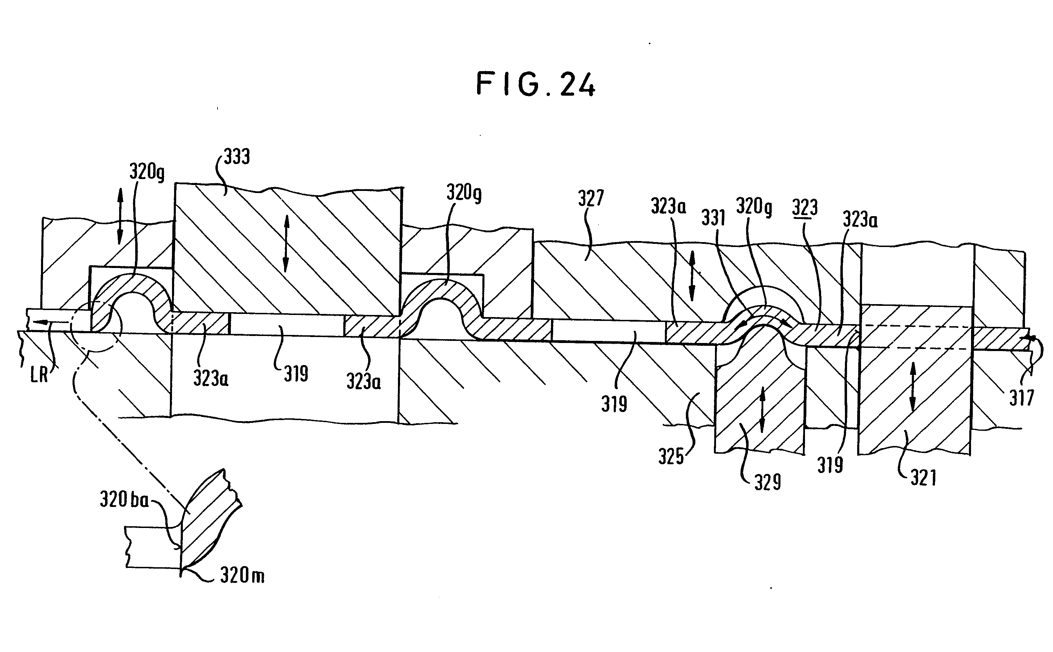

Die Fig. 18a und 18b zeigen das Entstehen des Magazinbandes gemäß Fig. 18c aus einem zunächst flachen Blechband 317. Aus diesem Blechband 317 werden zunächst die Pilotlöcher 315 ausgestanzt, um dann das registerhaltige Schalten des Blechbandes während der weiteren Bearbeitungsstationen in der Bandstanz- und Biegemaschine zu ermöglichen. Dann werden die Fenster 319 ausgestanzt wegen des Auswölbens der Wölbungen 320g der Kontaktbiegefedern 320k und 320l. Es wird nun auf Fig. 24 verwiesen. Mittels eines Stanzstempels 321 werden die Fenster 319 aus dem Blechband 317 ausgestanzt. Die zwischen aufeinanderfolgenden Fenstern 319 stehengebliebenen Stege 323 werden sodann zwischen einer unteren Klemmplatte 325 und einer oberen Klemmplatte 327 in ihren Randbereichen 323a festgeklemmt, worauf ein Wölbungsstempel 329 die Wölbung 320g im Mittelbereich des Steges 323 erzeugt. Die Klemmkraft zwischen den Klemmbacken 325 und 327 wird dabei so eingestellt, daß die Randbereiche 323a der Stege 323 zwischen den Klemmbacken 325, 327 bei der Auswölbung nachgezogen werden können, gleichwohl aber eine ausreichende Spannung in dem Wölbungsbereich 320g in Richtung des gekrümmten Pfeiles 331 erzeugt wird. Eine wesentliche Materialstärkenreduzierung findet deshalb in dem Wölbungsbereich 320g nicht statt.

Wie aus Fig. 24 zu ersehen, werden dann in einer weiteren Stanzstation (linker Bereich der Fig. 24) die Randbereiche 323a der Stege 323 von den Wölbungsbereichen 323g durch einen Beschneidungsstempel 333 abgeschnitten. Der Beschneidungsstempel 333 kann Teil eines Schnittwerkzeugs sein, das auch die Freilegung des Trägerbandes 307 und der Verbindungsbänder 309, 311 sowie der Lappen 313 innerhalb eines noch zusammenhängenden Filigranbandes gemäß Fig. 18a bewirkt.

Fig. 18b zeigt, wie aus dem in Fig. 18a mit strichpunktierten Linien angedeuteten Filigranband durch mehrere Biegeoperationen der Übergang zu dem Zustand der Fig. 18c rechts und letztlich zu dem Zustand der Fig. 18c links erfolgt. Im Zuge dieses Übergangs werden die Kontaktstifte 310, die in Pfeilrichtung 335 zugeführt werden, mit den beiden Kontaktbiegefedern 320k und 320l verschweißt.

Wie aus Fig. 24 ersichtlich, entstehen in den Kantbereichen der Wölbungen 320g scharfe Grate 320m.

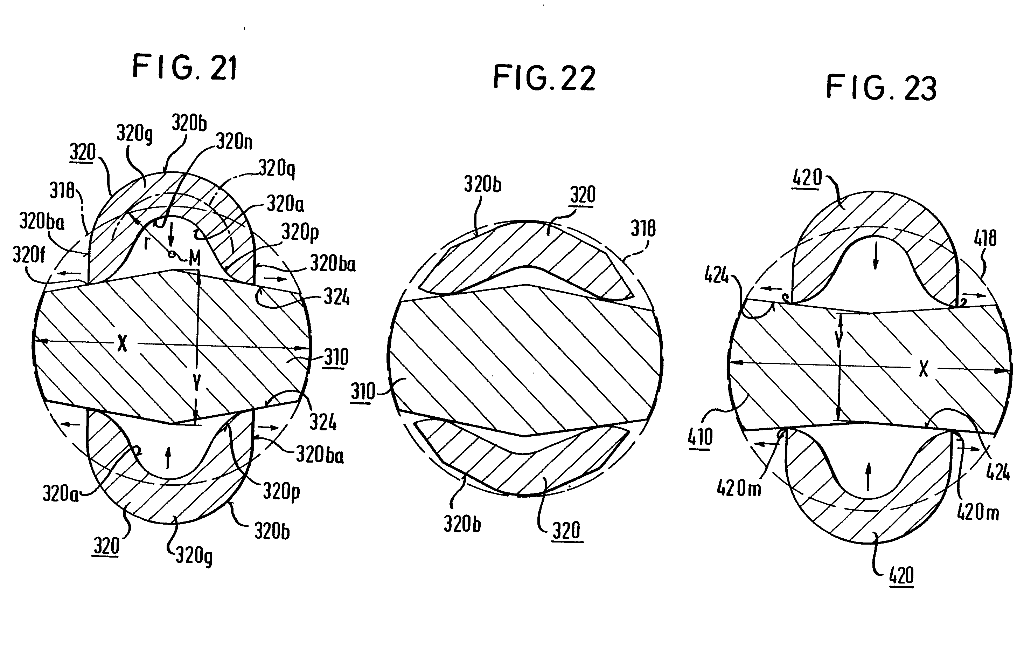

In Fig. 21 ist die aus Fig. 24 entstandene Form der Wölbung 320g vergrößert dargestellt. Bei dieser Ausführungsform sind jedoch die Grate 320m unterdrückt. Die Innenseite 320a der Wölbung 320g setzt sich zusammen aus einem konkaven Scheitelbereich 320n und konvexen Randbereichen 320p. Diese konvexen Bereiche 320p liegen an den als Dachflächen ausgestalteten Seitenflächen 324 an. Bei dieser Kombination von Formgebung der Seitenfläche 324 und Formgebung der Wölbungskanten ist ein eingrabungsfreies Gleiten der Wölbungskanten 320f auf den dachförmigen Seitenflächen 324 gewährleistet, so daß die an dieser Stelle auftretende Reibung nichts wesentliches zur Erhöhung der Federkraft in der Kontaktbiegefeder 320 beiträgt. Verantwortlich für eine hohe Kontaktfederkraft ist hier ausschließlich die Geometrie der Wölbung und die Reckorientierung in dem Wölbungsbereich. Zur Erläuterung der Geometrie des Wölbungsbereichs 320g ist der mittlere Krümmungskreis 320q eingeführt, der etwa in der Mitte zwischen der äußeren Fläche 320b und der inneren Fläche 320a liegt. Dieser Krümmungskreis 320q hat einen Krümmungsradius r. Die Länge des Krümmungsradius r beträgt etwa 1/2 der halben Länge der langen Achse X. Der Abstand des Krümmungsmittelpunkts M von der Seitenfläche 324 ist etwa 1/3 des Krümmungsradius r.

Die äußeren Randbereiche der Außenseite 320b sind mit 320ba bezeichnet ; sie sind vom Schnittvorgang gemäß der linken Hälfte der Fig. 24 her im wesentlichen parallel zu der kurzen Querschnittsachse Y.

Fig. 22 zeigt die Anpassung der äußeren Fläche 320b an den Umriß der Steckbuchse 318 bei einer Verformung der Biegefedern 320 durch Einstecken in die Steckbuchse 318.

Die Ausführungsform gemäß Fig. 23 unterscheidet sich von derjenigen gemäß Fig. 21 dadurch, daß die Seitenflächen 424 als Flachrinnenflächen ausgeführt sind. Gleichzeitig sind hier die Randgrate 420m stehengeblieben, so daß ein sehr hoher Reibungskoeffizient zwischen den Randgraten 420m und den Flachrinnenflächen 424 besteht und beim Flachdrücken der Kontaktbiegefedern 420 ggf. sogar eine Spanablösung erfolgen kann, wie in Fig. 23 dargestellt.

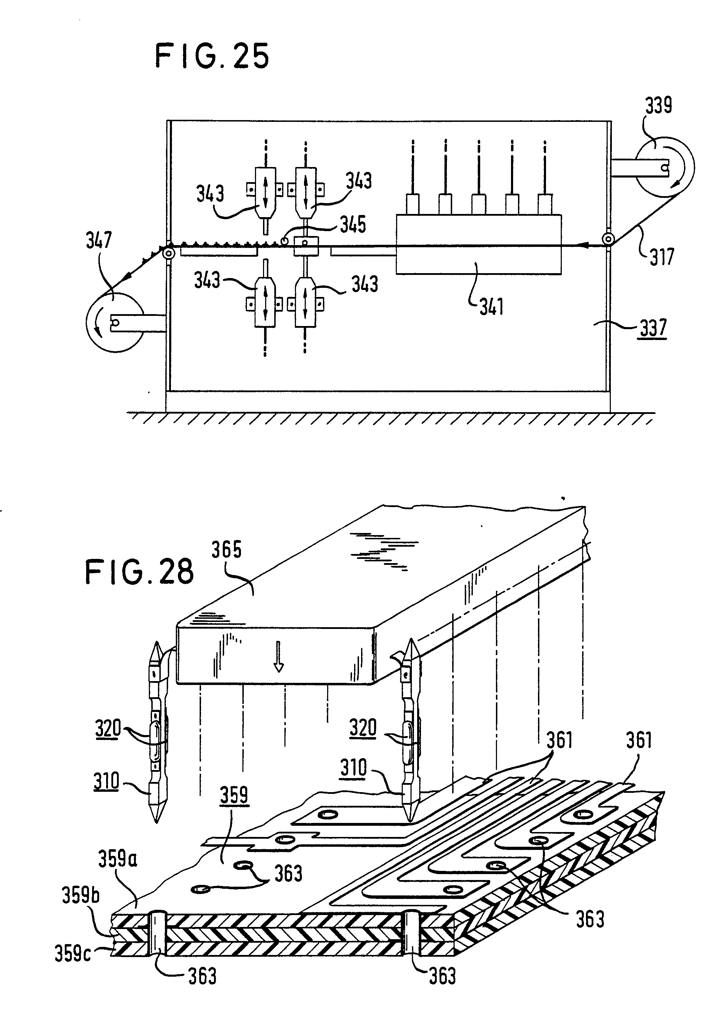

In Fig. 25 ist das Schema einer Bandstanz- und Biegemaschine 337 dargestellt. Man erkennt dort einen Bandmaterialvorrat 339, von dem das Blechband 317 abläuft. In einer Stanz- und Wölbungseinheit 341 erfolgen die Stanz- und Wölbungsvorgänge entsprechend Fig. 18a und rechte Hälfte der Fig. 18b. Durch schematisch angedeutete Biegeeinheiten 343 erfolgen die Biegevorgänge gemäß linke Hälfte der Fig. 18b und rechte Hälfte der Fig. 18c. Die Grundstifte werden senkrecht zur Zeichenebene der Fig. 25 etwa bei 345 zugeführt. Das fertige Magazinband wird dann auf. eine Vorratsspule 347 aufgerollt.

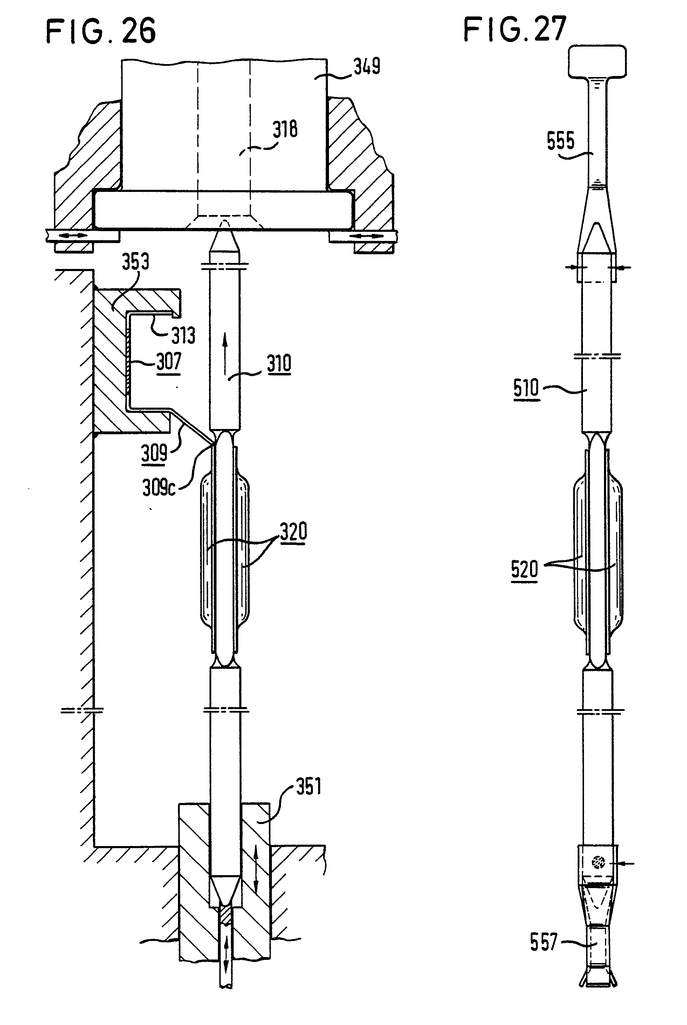

Gemäß Fig. 26 wird ein Magazinband, wie es in Fig. 19 und 20 dargestellt ist, in einen Grundstiftaufnahmeträger 349 eingestoßen, der mit schematisch angedeuteten Steckbuchsen 318 ausgeführt ist. Vor diesem Einstoßvorgang wurden bereits die zweiten Verbindungsbänder abgebrochen, so daß nur noch die ersten Verbindungsbänder 309 bestehen, welche die Kontaktstifteinheiten an dem zu einem U-förmigen Führungsprofil ergänzten Trägerband 307 halten. Das Einstoßen erfolgt durch Einstoßestempel 351. Bei diesem Einstoßvorgang tritt ggf. nach einer Verbiegung der ersten Verbindungsbänder 309 ein Bruch an der Sollbruchstelle 309c ein. Das Trägerband 307 ist in einer Führungsbahn 353 der Vorrichtung geführt. Es ist auch möglich, nach teilweisem Einstoßen der Kontaktstift-Baugruppen in die Buchsen 318 das Trägerband 307 beispielsweise mittels eines Hilfswerkzeugs unter Brechung der Sollbruchstellen 309c reißverschlußartig abzureißen.

Gemäß Fig. 27 sind an beiden Enden eines Grundstifts 510 Lötfahnen 555 und Steckkontakte 557 angebracht, nur um die vielseitige Ausgestaltungsmöglichkeit der Grundstifte 510 mit erfindungsgemäßen Kontaktbiegefedern 520 zu veranschaulichen.

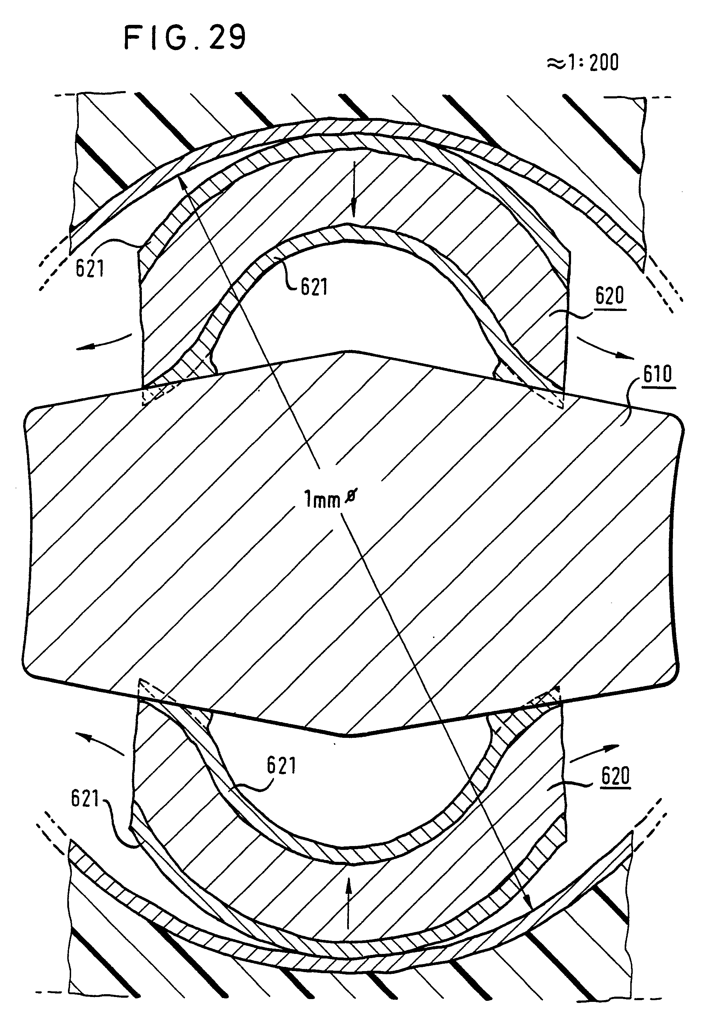

In Fig. 28 ist eine Mehrschichtleiterplatte mit 359 bezeichnet. Diese Mehrschichtleiterplatte 359 besteht aus drei Schichten 359a, 359b und 359c. Auf jeder dieser Schichten sind Leiterbahnen. Jede dieser Leiterbahnen wird von einem sämtliche Schichten durchsetzenden Steckloch 363 durchsetzt. Die Grundstifte 310 greifen mit ihren Kontaktfedern 320 je nach der Lage der Leiterbahnen auf den verschiedenen Schichte in verschiedener Höhenlage der Stecklöcher an den Leiterbahnen an. Die Grundstifte 310 können beispielsweise an einem Chip 365 befestigt sein. Die Federn liegen dank ihrer Form an jeder Schicht mit dem gewünschten Kontaktdruck an, so daß es z. B. auch möglich ist, Leiterbahnen verschiedener Etagen elektrisch miteinander zu verbinden, auch dann, wenn die Lochweite in den verschiedenen Etagen Toleranzen hat. Das Ausmaß der Flachpressung der Federn kann nämlich von Etage zu Etage variieren.

Die Grundstifte 310 gemäß Fig. 21 bis 23 können beispielsweise aus Phosphorbronze oder Berylliumkupfer hergestellt sein. Die Kontaktbiegefedern sind vorzugsweise aus rostfreiem Stahl hergestellt und mit Kupfer überzogen. Zu den Maßverhältnissen gilt das im Zusammenhang mit den Ausführungsbeispielen gemäß Fig. 1 bis 29 gesagte.

Die Schnittdarstellung der Fig. 29 ist nach einem Schliffbild gezeichnet worden. Man erkennt, daß die Federn 620, die beispielsweise aus V2A-Stahl hergestellt sind, mit Kupferschichten 621 überzogen sind. Diese Kupferschichten sind im Vergleich zum Werkstoff des Kontaktstifts 610 relativ weich, so daß sie sich beim Flachdrücken der Federn 620 deformieren können, wie aus Fig. 29 zu ersehen. Tatsächlich wurde festgestellt, daß sich die Randbereiche der am Grundstift 610 anliegenden Kupferschichten 621 aus der durch die gestrichelte Linie dargestellten ursprünglichen Form zu der mit ausgezogenen Linien dargestellten Fußform quetschen lassen. Diese Fußform sorgt für eine relativ großflächige Anlage zwischen den grundstiftseitigen Kupferschichten 621 und dem Grundstift 610 mit der Folge eines geringen Übergangswiderstands an den Berührungsstellen und entsprechend geringem Spannungsabfall. Diese Erscheinung ist unabhängig davon, ob an den Kanten der Federn 620 Grate vorhanden sind, wie in Fig. 24 bei 320m angedeutet, oder nicht.

**Patentansprüche**

1. Kleinformatige elektrische Kontaktstiftbaugruppe zum Eingriff mit einer, insbesondere in einer Leiterplatte angeordneten, Steckerbuchse (14) von annähernd kreisrundem Querschnitt ; diese Kontaktstiftbaugruppe umfasst mindestens einen Grundstift (10 ; 210 ; 310 ; 410 ; 510 ; 610) und eine an diesem Grundstift angeordnete Kontaktbiegefeder (20 ; 220 ; 320 ; 420 ; 520 ; 620), welche an dem Grundstift abgestützt ist, leitende Verbindung mit dem Grundstift hat und zum elektrischen Kontakteingriff unter radialer Spannung mit dem Innenumfang der Steckerbuchse (14) bemessen ist, dadurch gekennzeichnet, daß der Querschnitt des Grundstifts auf mindestens einem Teilabschnitt (A) seiner Länge länglich ist mit einer langen Querschnittsachse (X), deren Länge annähernd dem Innendurchmesser der Steckerbuchse (14) entspricht, und mit einer kurzen Querschnittsachse (Y), und daß an mindestens einer zur kurzen Querschnittsachse (Y) im wesentlichen senkrechten Seitenfläche (24 ; 224 ; 324 ; 424 ; 524 ; 624) des Teilabschnitts (A) des Grundstifts die in Längsrichtung des Grundstifts (10) verlaufende Kontaktbiegefeder angeordnet ist, welche an dieser im wesentlichen senkrechten Seitenfläche abgestützt ist.

2. Kontaktstift-Baugruppe nach Anspruch 1, dadurch gekennzeichnet, daß die Kontaktbiegefeder (20) eine Blattfeder mit länglichem Querschnitt ist, dessen lange Querschnittsachse annähernd parallel zur langen Querschnittsachse (X) des länglichen Querschnitts des Teilabschnitts (A) des Grundstifts (10) ist.

3. Kontaktstiftbaugruppe nach Anspruch 2, dadurch gekennzeichnet, daß die Kontaktfeder (20), in zur Grundstiftachse senkrechtem Querschnitt betrachtet, gewölbt ist mit einer dem Grundstift (10) zugekehrten konkaven, inneren Seite (20a) und einer dem Innenumfang der Steckerbuchse (14) zugekehrten konvexen, äußeren Seite (20b), wobei im gespannten Zustand der Kontaktfeder (20) die Scheitellinie der konkaven inneren Seite (20a) von der zur kurzen Querschnittsachse (Y) im wesentlichen senkrechten Seitenfläche (24) Abstand hat und die Kontaktfeder im Bereich der Längskanten ihrer konkaven Innenseite (20a) an der zur kurzen Querschnittsachse (Y) im wesentlichen senkrechten Seitenfläche (24) abgestützt ist.

4. Kontaktstift-Baugruppe nach Anspruch 3, dadurch gekennzeichnet, daß der Krümmungsradius der äußeren Seite (20b) des Blattfederquerschnitts geringfügig kleiner bis höchstens gleich dem Innenradius der Steckerbuchse (14) ist.

5. Kontaktstift-Baugruppe nach einem der Ansprüche 1 bis 4, dadurch gekennzeichnet, daß die Kontaktbiegefeder (20) in Längsrichtung des Grundstifts (10) bogenförmig verläuft mit einer dem Teilabschnitt (A) des Grundstifts zugekehrten konkaven Bogenkrümmung und einer dem Innenumfang der Steckerbuchse (14) zugekehrten konvexen Bogenkrümmung.

6. Kontaktstift-Baugruppe nach Anspruch 5, dadurch gekennzeichnet, dass die Kontaktfeder (20) derart gekrümmt ist, daß mindestens nach Herstellung der Steckverbindung beide Bogenenden an dem Teilabschnitt (A) des Grundstifts in radialer Richtung abgestützt sind.

7. Kontaktstift-Baugruppe nach einem der Ansprüche 5 und 6, dadurch gekennzeichnet, daß die Kontaktbiegefeder (20) an einem ersten Ende an dem Grundstift (10) befestigt ist und an dem zweiten Ende (20a) an dem Teilabschnitt (A) des Grundstifts (10) in dessen Längsrichtung verschiebbar anliegt.

8. Kontaktstift-Baugruppe nach Anspruch 7, dadurch gekennzeichnet, daß die Kontaktbiegefeder (20) an dem zweiten Ende (20a) einem Anschlag (34) gegenübersteht, welcher ihre Verschiebbarkeit in Längsrichtung des Grundstifts (10) beschränkt.

9. Kontaktstift-Baugruppe nach Anspruch 8, dadurch gekennzeichnet, daß der Anschlag (34) derart auf die Länge der Kontaktbiegefeder und auf den Innendurchmesser der Steckerbuchse (14) abgestimmt ist, daß das zweite Ende (20a) zum Anschlag kommt, bevor die Kontaktbiegefeder (20) mit ihrem Scheitel in die Steckerbuchse (14) eintritt.

10. Kontaktstift-Baugruppe nach einem der Ansprüche 1 bis 9, dadurch gekennzeichnet, daß die Kontaktbiegefeder (20) an einem Ende mit dem Grundstift (10) verschweißt oder verlötet ist.

11. Kontaktstift-Baugruppe nach einem der Ansprüche 1 bis 10, dadurch gekennzeichnet, daß zwei Kontaktbiegefedern (20) zusammen mit einem ihrer Befestigung an und/oder elektrischen Leitungsverbindung mit dem Grundstift (10) dienenden Anschlußteil (28) einstückig hergestellt sind.

12. Kontaktstift-Baugruppe nach Anspruch 11, dadurch gekennzeichnet, daß das Anschlußteil (28) U-förmig ausgebildet ist mit einem Steg (28a), welcher an einem zur langen Querschnittsachse (X) des länglichen Querschnitts des Teilabschnitts (A) senkrechten Seitenflächenbereich (30a) des Grundstifts (10) anliegt, und mit zwei Schenkeln (28b), welche an den zur kurzen Querschnittsachse (Y) des länglichen Querschnitts des Teilabschnitts (A) senkrechten Seitenflächen (24) des Teilabschnitts (A) anliegen, und daß die Kontaktbiegefedern (20) von beiden Schenkeln (28b) ausgehen.

13. Kontaktstift-Baugruppe nach Anspruch 12, dadurch gekennzeichnet, daß der Steg (28a) an einem zur langen Querschnittsachse (X) des länglichen Querschnitts senkrechten Seitenflächenbereich (30a) des Grundstifts (10) anliegt, welcher gegenüber der zugehörigen durch die lange Querschnittsachse (X) definierten Seitenfläche (26) des Teilabschnitts (A) zur Grundstiftachse hin zurückversetzt ist.

14. Kontaktstift-Baugruppe nach einem der Ansprüche 12 und 13, dadurch gekennzeichnet, daß der Steg (28a) und/oder mindestens einer der Schenkel (28b) mit dem ihm jeweils anliegenden Seitenflächenbereich des Grundstifts (10) verlötet oder verschweißt sind.

15. Kontaktstift-Baugruppe nach einem der Ansprüche 1 bis 14, dadurch gekennzeichnet, daß die zu der langen Querschnittsachse (X) des länglichen Querschnitts des Teilabschnitts (A) senkrechten Seitenflächen (26) des Teilabschnitts (A) zum Innenumfang der Steckerbuchse (14) hin konvex gerundet sind.

16. Kontaktstift-Baugruppe nach einem der Ansprüche 1 bis 15, dadurch gekennzeichnet, daß die zur langen Querschnittsachse (X) des länglichen Querschnitts senkrechten Seitenflächen (126) des Teilabschnitts (A) zumindest an ihrem beim Einstecken vorlaufenden Enden in Einsteckrichtung aufeinanderzukonvergieren.

17. Kontaktstift-Baugruppe nach einem der Ansprüche 1 bis 16, dadurch gekennzeichnet, daß der längliche Querschnitt des Grundstifts (10) in dem Teilabschnitt (A) durch Flachdrücken eines den Grundstift (10) bildenden Drahtstücks gebildet ist.

18. Kontaktstift-Baugruppe nach Anspruch 17, dadurch gekennzeichnet, daß das Drahtstück (10) quadratischen Querschnitt besitzt, und daß die Achsen (X, Y) des länglichen Querschnitts in dem flachgedrückten Teilabschnitt (A) in die Längsachse des Drahtstücks (10) enthaltenden Ebenen liegen, die auch je eine Querschnittsachse des quadratischen Querschnitts enthalten.

19. Kontaktstift-Baugruppe nach einem der Ansprüche 17 und 18, dadurch gekennzeichnet, daß der Anschlag (34) für die Kontaktbiegefeder (20) durch die Übergangsschulter von dem flachgedrückten Teilabschnitt (A) zu einem anschließenden unverformten Drahtabschnitt (C) gebildet ist, wobei an dieser Übergangsschulter (34) gegebenenfalls eine Haltenase (36) angeformt ist, welche die Kontaktbiegefeder zumindest nach Erreichen des Anschlags (34) übergreift.

20. Kontaktstift-Baugruppe nach einem der Ansprüche 17 bis 19, dadurch gekennzeichnet, daß der Teilabschnitt (A) an mindestens einem Ende einen flachgedrückten Übergangsabschnitt (D) aufweist, dessen kurze Querschnittsachse in ihrer Länge der kurzen Querschnittsachse (Y) des flachgedrückten länglichen Querschnitts des Teilabschnitts (A) entspricht und dessen lange Achse der entsprechenden Achse des unverformten Drahtstücks entspricht oder kleiner ist als diese, und daß der Anschlußteil (28) an diesem Übergangsabschnitt (D) anliegt.

21. Kontaktstift-Baugruppe nach einem der Ansprüche 17 bis 20, dadurch gekennzeichnet, daß die Schenkel (28b) des Anschlußteils (28) mit ihren von den Kontaktbiegefedern (20) abgelegenen Kanten (28c) an Übergangsschultern (32) zwischen dem flachgedrückten Teilabschnitt (A) und einem anschliessenden Abschnitt (B) des unverformten Drahtstücks (10) anliegen.

22. Kontaktstift-Baugruppe nach einem der Ansprüche 1 bis 21, dadurch gekennzeichnet, daß der Innendurchmesser der Steckerbuchse (14) kleiner ist als 2,5 mm, insbesondere ca. 1 mm.

23. Kontaktstift-Baugruppe nach Anspruch 22, dadurch gekennzeichnet, daß die Länge der langen Achse (X) des länglichen Querschnitts sich zur Länge der kurzen Achse (Y) des länglichen Querschnitts wie 1,5 : 1-4 : 1, vorzugsweise ca. 2 : 1-3 : 1 verhält.

24. Kontaktstift-Baugruppe nach einem der Ansprüche 22 und 23, dadurch gekennzeichnet, daß die Dicke der Blattfeder ca. 5/100 bis ca. 20/100 mm beträgt.

25. Kontaktstift-Baugruppe nach einem der Ansprüche 1 bis 21, dadurch gekennzeichnet, daß das Verhältnis der Länge des Teilabschnitts (A) zum Innendurchmesser der Steckerbuchse (14) 2 : 1 bis 4 : 1, vorzugsweise ca. 3 : 1, beträgt.

26. Kontaktstift-Baugruppe nach einem der Ansprüche 1 bis 25, dadurch gekennzeichnet, daß die Steckerbuchse (14) von einem innen metallisierten Loch, insbesondere verzinnten Loch (18), einer Leiterplatte (16) gebildet ist.

27. Kontaktstift-Baugruppe nach einem der Ansprüche 2 bis 26, dadurch gekennzeichnet, daß die Blattfeder (220) an ihrem freien Ende gerundet oder zugespitzt ist, insbesondere, wenn das freie Ende der Blattfeder (220) in Einschubrichtung vorläuft.

28. Kontaktstift-Baugruppe nach einem der Ansprüche 7 bis 27, dadurch gekennzeichnet, daß das erste Ende der Kontaktbiegefeder in Einschubrichtung vorläuft.

29. Kontaktstift-Baugruppe nach einem der Ansprüche 1 bis 27, dadurch gekennzeichnet, daß das zweite Ende der Kontaktbiegefeder in Einschubrichtung vorläuft.

30. Kontaktstift-Baugruppe nach einem der Ansprüche 3 und 4, 11 bis 18 und 20 bis 26, dadurch gekennzeichnet, daß die Kontaktbiegefeder (320) im gespannten Zustand und vorzugsweise auch im entspannten Zustand mit ihren Längskantenbereichen (320f) im wesentlichen auf deren gesamter Länge an den zur kurzen Querschnittsachse (Y) im wesentlichen senkrechten Seitenflächen (324) anliegt.

31. Kontaktstift-Baugruppe nach einem der Ansprüche 3 und 4, 11 bis 18, 20 bis 26 und 30, dadurch gekennzeichnet, daß die Kontaktbiegefeder (320) wenigstens auf einem Teil ihrer Länge badewannenförmig gewölbt ist (bei 320g), wobei zumindest die Längskantenbereiche (320f) der Badewannenwölbung (320g) im gespannten Zustand und vorzugsweise auch im entspannten Zustand an der zur kurzen Querschnittsachse (Y) senkrechten Seitenfläche (324) anliegen.

32. Kontaktstift-Baugruppe nach Anspruch 31, dadurch gekennzeichnet, daß die Kontaktbiegefeder (320) an mindestens einem Ende mit einem die badewannenförmige Auswölbung (320g) in Federlängsrichtung fortsetzenden Endflansch (320h) versehen ist, und daß dieser Endflansch (320h) an der zugehörigen zu der kurzen Querschnittsachse (Y) senkrechten Seitenfläche (324) anliegt und mit dieser ggf. verlötet oder verschweißt ist.

33. Kontaktstift-Baugruppe nach einem der Ansprüche 3, 11 bis 18, 20 bis 26 und 30 bis 32, dadurch gekennzeichnet, daß im entspannten Zustand der Kontaktbiegefeder (320) der mittlere Krümmungskreis (320q) der Wölbung (320g) der Kontaktbiegefeder (320) seinen Mittelpunkt (M) außerhalb der zugehörigen zur kurzen Querschnittsachse (Y) im wesentlichen senkrechten Seitenflächen (324) hat und einen Krümmungsradius (r) hat, weicher wesentlich kleiner ist als die Hälfte der langen Querschnittsachse (X).

34. Kontaktstift-Baugruppe nach Anspruch 33, dadurch gekennzeichnet, daß der Abstand des Mittelpunkts (M) des mittleren Krümmungskreises (320) von der zugehörigen zur kurzen Querschnittsachse (Y) senkrechten Seitenfläche (324) ca. ein Drittel bis ca. zwei Drittel, vorzugsweise ca. ein halb, des Krümmungsradius (r) des mittleren Krümmungskreises (320q) beträgt.

35. Kontaktstift-Baugruppe nach einem der Ansprüche 33 und 34, dadurch gekennzeichnet, daß der Krümmungsradius (r) des mittleren Krümmungskreises (320q) ca. ein Drittel bis ca. zwei Drittel, vorzugsweise ca. ein halb, der halben Länge der langen Querschnittsachse (X) beträgt.

36. Kontaktstift-Baugruppe nach einem der Ansprüche 33 bis 35, dadurch gekennzeichnet, daß die innere Seite (320a) der Wölbung (320g) im Scheitelbereich (320n) konkav und im Kantenbereich (320p) konvex geformt ist.

37. Kontaktstift-Baugruppe nach Anspruch 36, dadurch gekennzeichnet, daß die Kontaktbiegefeder (320) mit der konvex gekrümmten Fläche (320p) des Kantenbereichs (320f) an der zur kurzen Querschnittsachse (Y) im wesentlichen senkrechten Seitenfläche (324) anliegt.

38. Kontaktstift-Baugruppe nach einem der Ansprüche 33 bis 37, dadurch gekennzeichnet, daß die zur kurzen Querschnittsachse (Y) im wesentlichen senkrechten Seitenflächen (324) als Planflächen oder Dachflächen ausgebildet sind.

39. Kontaktstift-Baugruppe nach einem der Ansprüche 33 bis 36 und 38, dadurch gekennzeichnet, daß die Kontaktbiegefeder (420) mit scharfen Kanten (420m) an der zugehörigen, zur kurzen Querschnittsachse (Y) im wesentlichen senkrechten Seitenfläche (324) anliegt.

40. Kontaktstift-Baugruppe nach einem der Ansprüche 33 bis 37 und 39, dadurch gekennzeichnet, daß die zur kurzen Querschnittsachse (Y) im wesentlichen senkrechten Seitenflächen (424) als Flachrinnenflächen ausgebildet sind.

41. Kontaktstift-Baugruppe nach einem der Ansprüche 33 bis 40, dadurch gekennzeichnet, daß die äußere Seite (320b) der Wölbung (320g) der Kontaktbiegefeder (320) im Scheitelbereich konvex ist und im Kantenbereich (320ba) im wesentlichen parallel zur kurzen Querschnittsachse (Y) ausgebildet ist.

42. Kontaktstift-Baugruppe nach einem der Ansprüche 3 bis 41, dadurch gekennzeichnet, daß das Material der Kontaktbiegefeder (320) in Richtung des Krümmungsumfangs (331) der Wölbung (320g) reckorientiert ist.

43. Kontaktstift-Baugruppe nach einem der Ansprüche 17, 18, 22 bis 26 und 30 bis 42, dadurch gekennzeichnet, daß die Seitenflächen (324, 326) des Teilabschnitts (A) im wesentlichen stetig in die entsprechenden Seitenflächen des Grundstifts (310) übergehen.

44. Kontaktstift-Baugruppe nach einem der Ansprüche 1 bis 43, dadurch gekennzeichnet, daß der Grundstift (510) an mindestens einem Ende mit einem Steckkontaktteil (555, 557) versehen ist.

45. Kontaktstift-Baugruppe nach einem der Ansprüche 1 bis 44, dadurch gekennzeichnet, daß eine Mehrzahl von Grundstiften (310) in Form eines Magazinstreifens zusammenhängen.

46. Kontaktstift-Baugruppe nach Anspruch 45, dadurch gekennzeichnet, daß die Kontaktbiegefedern (320) aus einem Blechband (317) durch Ausstanzen und Biegen gebildet sind und die Grundstifte (310) durch bei der Bildung der Kontaktbiegefedern (320) verbleibende Reste des Blechbands (317) zum Magazinstreifen verbunden sind.

47. Kontaktstift-Baugruppe nach einem der Ansprüche 45 und 46, dadurch gekennzeichnet, daß zwischen den Kontaktbiegefedern (320) und den die Grundstifte (310) zum Magazinband verbindenden Resten des Blechbands (317) Sollbruchstellen (309c, 311d, 311e) vorgesehen sind.

48. Kontaktstift-Baugruppe nach einem der Ansprüche 45 bis 47, dadurch gekennzeichnet, daß die die Grundstifte (310) zum Magazinband verbindenden Reste des Blechbands (317) mit Führungsmitteln (313) und/oder Fortschaltmitteln (315) zum Transport des Magazinbands durch Bearbeitungseinrichtungen versehen sind.

49. Kontaktstift-Baugruppe nach einem der Ansprüche 46 bis 48, dadurch gekennzeichnet, daß die die Grundstifte (310) zum Magazinband verbindenden Reste des Blechbands (317) ein quer zur Längsrichtung der Grundstifte und parallel zu den die Kontaktstiftfedern tragenden Seitenflächen (324) der Grundstifte verlaufendes Trägerband (307) auf einer Seite (324l) der Grundstifte (310) umfassen und daß dieses Trägerband (307) mit den auf derselben Seite (324l) der Grundstifte (310) liegenden Kontaktbiegefedern (320l) über erste Verbindungsbänder (309) verbunden ist, welche im wesentlichen in einer zur Längsrichtung des Trägerbands (307) senkrechten, durch den jeweiligen Grundstift (310) gehenden Ebene (E1) liegen und/oder mit den auf der anderen Seite (324k) der Grundstifte (310) liegenden Kontaktbiegefedern (320k) durch weitere Verbindungsbänder (311) verbunden ist, welche außerhalb dieser Ebene (E1) liegen.

50. Kontaktstift-Baugruppe nach Anspruch 49, dadurch gekennzeichnet, daß die Ebene des Trägerbands (307) im wesentlichen parallel zur Längsrichtung der Grundstifte (310) ist und daß das erste Verbindungsband (309) einen ersten Bandabschnitt (309a) im wesentlichen senkrecht zur Ebene des Trägerbands (307) aufweist und einen zweiten, gegen die Längsrichtung des jeweiligen Grundstifts (310) geneigten Bandabschnitt (309b) aufweist, welcher zum benachbarten Ende der jeweiligen Kontaktbiegefeder (320l) verläuft, wobei eine Sollbruchstelle (309c) am Übergang von dem zweiten Bandabschnitt (309b) zu der Kontaktbiegefeder (320l) vorgesehen ist.

51. Kontaktstift-Baugruppe nach Anspruch 49 oder 50, dadurch gekennzeichnet, daß das zweite Verbindungsband (311) einen mehrfach abgewinkelten Bandabschnitt (311a, 311b) aufweist, welcher von dem Trägerband (307) ausgehend in einer zur Längsrichtung (LR) des Trägerbands (307) im wesentlichen senkrechten gegenüber dem jeweiligen Grundstift (310) seitlich versetzten Ebene (E2) liegt und einem zum Trägerband (307) im wesentlichen parallelen Fortsetzungsbandabschnitt (311c), welcher den mehrfach abgewinkelten Bandabschnitt (311a, 311b) mit der auf der jeweils anderen Seite (324k) liegenden Kontaktbiegefeder (320k) verbindet, wobei die Ebene des Trägerbands (307) im wesentlichen parallel zur Längsrichtung der Grundstifte (310) ist, ein erster Teilabschnitt (311a) des mehrfach abgewinkelten Bandabschnitts (311a, 311b) an das Trägerband (307) unter einem ersten Winkel β anschließt und über die vom Trägerband abgelegene Seitenflächen (324k) des zugehörigen Grundstifts (310) hinausragt, ein zweiter Teilabschnitt (311b) des mehrfach abgewinkelten Bandabschnitts (311a, 311b) unter einem zweiten Winkel γ gegenüber dem ersten Teilabschnitt (311a) in die Ebene der von dem Trägerband (310) abgelegenen Seitenfläche (324k) zurückläuft und an den Fortsetzungsbandabschnitt (311c) anschließt und wobei am Übergang von dem Trägerband (307) zu dem ersten Teilabschnitt (311a) und/oder an dem Übergang von dem Fortsetzungsbandabschnitt (311c) zu der jeweiligen Kontaktbiegefeder (320k) Sollbruchstellen (311e bzw. 311d) vorgesehen sind.

52. Kontaktstift-Baugruppe nach einem der Ansprüche 49 bis 51, dadurch gekennzeichnet, daß das Trägerband (307) durch im wesentlichen senkrecht zu seiner Ebene abgewinkelte Lappen (313) versteift ist, die ein im wesentlichen U-förmiges Führungsprofil ergeben.

53. Kontaktstift-Baugruppe nach einem der Ansprüche 49 bis 52, dadurch gekennzeichnet, daß die beiden Enden der Grundstifte (310) in deren Längsrichtung über das Trägerband (307) und die Verbindungsbänder (309, 311) überstehen.

54. Kontaktstift-Baugruppe nach einem der Ansprüche 1 bis 53, dadurch gekennzeichnet, daß die Kontaktbiegefeder (620) zumindest auf ihrer dem Grundstift (610) zugekehrten Seite mit einer gegenüber dem Material der Kontaktbiegefeder (620) und dem Material des Grundstifts (610) weicheren Beschichtung (621) von guter Leitfähigkeit, z. B. einer Weichkupferschicht, versehen ist, welche längs der an dem Grundstift (610) anliegenden Ränder der Kontaktbiegefeder (620) eine Verformung zur großflächigeren Anlage an dem Grundstift (610) erfährt, wenn die Kontaktbiegefeder (620) gegen den Grundstift (610) angedrückt wird.

55. Verfahren zur Herstellung der Kontaktbiegefedern für Kontaktstiftbaugruppen nach einem der Ansprüche 3 bis 54, dadurch gekennzeichnet, daß man die Wölbung (320g) unter Reckorientierung des Federmaterials im Wölbungsbereich (320g) mit einer zur Wölbungsumfangsrichtung (331) parallelen Orientierungsrichtung durchführt.

56. Verfahren nach Anspruch 55, dadurch gekennzeichnet, daß man bei Herstellung der Kontaktbiegefedern (320) aus einem Blechband (317) vor der Herstellung der Wölbung (320g) in dem Blechband (317) im Abstand von den Kanten der jeweiligen Kontaktbiegefeder (320) Schlitze (319) im Blechband (317) vorsieht, die Randbereiche (323a) des zwischen den Schlitzen (319) verbleibenden Materialstegs (323) einklemmt, den Mittelbereich dieses Materialstegs (323) unter Einbringung der Reckorientierung auswölbt und die Randbereiche (323a) hierauf beschneidet.

57. Verfahren zur Herstellung einer Kontaktstift-Baugruppe nach einem der Ansprüche 49 bis 53 aus Grundstiften und einem die Kontaktbiegefedern ergebenden Blechband, dadurch gekennzeichnet, daß das Blechband (317) in einer Vorschubrichtung (LR) senkrecht zur Zuführungsrichtung der Grundstifte (310) bewegt wird, daß aus dem Blechband durch Stanzoperationen ein die Kontaktbiegefedern für die beiden Seitenflächen (324k, 324l) des Grundstifts (310), das Trägerband (307) und die Verbindungsbänder (309, 311) enthaltender Filigranstreifen gewonnen wird, in welchem die Kontaktbiegefedern für die beiden Seitenflächen (324k, 324l) von dem Trägerband (307) in entgegengesetzter Richtung quer zur Längsrichtung des Trägerbands (307) abstehen, daß die Grundstifte (310) mit einer Seitenfläche (324l) an die zugehörigen Kontaktfedern (320l) angelegt werden und ggf. mit diesen ein- oder mehrfach verlötet oder verschweißt werden und hierauf die zweite Kontaktbiegefeder (320k) auf die jeweils andere Seitenfläche (324k) der Grundstifte (310) geklappt und mit diesen ggf. ein- oder mehrfach verschweißt oder verlötet werden.

58. Verfahren zum Einbau von Kontaktstift-Baugruppen nach einem der Ansprüche 49 bis 54 in einem Grundstiftaufnahmeträger, dadurch gekennzeichnet, daß vorab die zweiten Verbindungsbänder (311) abgetrennt werden und daß die ersten Verbindungsbänder (309) nach oder während des Einbringens der Grundstifte (310) in den Grundstiftaufnahmeträger (349) abgebrochen werden.

59. Verfahren nach Anspruch 58, dadurch gekennzeichnet, daß die ersten Verbindungsbänder (309) durch Verschieben der Grundstifte (310) in ihrer Längsrichtung gegenüber dem Trägerband (307) abgebrochen werden.

60. Leiterplatte mit einer Kontaktstift-Baugruppe nach einem der Ansprüche 1 bis 54, dadurch gekennzeichnet, daß die Leiterplatte (359) als Mehrschichtleiterplatte ausgebildet ist.

## Claims

1. Electric contact pin assembly of small format for engagement with a plug socket (14) of approximately circular cross-section, especially arranged in a circuit board ; this contact pin assembly comprises at least one basic pin (10, 210, 310, 410, 510, 610) and a contact flexure spring (20, 220, 320, 420, 520, 620) arranged on this basic pin, which is supported on the basic pin, has conductive connection with the basic pin and is dimensioned for electric contact engagement under radial stress with the internal circumference of the plug socket (14), characterised in that the cross-section of the basic pin is elongated over at least a partial section (A) of its length with a long cross-sectional axis (X) the length of which corresponds approximately to the internal diameter of the plug socket (14) and with a short cross-sectional axis (Y), and in that on at least one side face (24, 224, 324, 424, 524, 586), substantially perpendicular to the short cross-sectional axis (Y), of the partial section (A) of the basic pin there is arranged the contact flexure spring extending in the longitudinal direction of the basic pin (10), which spring is supported on this substantially perpendicular side face.

2. Contact pin assembly according to Claim 1, characterised in that the contact flexure spring (20) is a leaf spring with elongated cross-section, the long cross-sectional axis of which is approximately parallel to the long cross-sectional axis (X) of the elongated cross-section of the partial section (A) of the basic pin (10).

3. Contact pin assembly according to Claim 2, characterised in that the contact spring (20), considered in cross-section perpendicular to the basic pin axis, is domed with a concave inner side (20a) facing the basic pin (10) and a convex outer side (20b) facing the internal circumference of the plug socket (14), while when the contact spring (20) is in the stressed condition the apex line of the concave inner side (20a) is spaced from the side face (24) substantially perpendicular to the short cross-sectional axis (Y) and the contact spring is supported in the region of the longitudinal edges of its concave inner side (20a) on the side face (24) substantially perpendicular to the short cross-sectional axis (Y).

4. Contact pin assembly according to Claim 3, characterised in that the radius of curvature of the outer side (20b) of the leaf spring cross-section is slightly smaller than or at most equal to the internal radius of the plug socket (14).

5. Contact pin assembly according to Claims 1 to 4, characterised in that the contact flexure spring (20) extends in arcuate form in the longitudinal direction of the basic pin (10) with a concave arcuate curvature facing the partial section (A) of the basic pin and a convex arcuate curvature facing the internal circumference of the plug socket (14).

6. Contact pin assembly according to Claim 5, characterised in that the contact spring (20) is curved in such a way that at least after the production of the plug connection the two arc ends are supported in the radial direction on the partial section (A) of the basic pin.

7. Contact pin assembly according to one of Claims 5 and 6, characterised in that the contact flexure spring (20) is secured on a first end on the basic pin (10) and at the second end (20a) lies on the partial section (A) of the basic pin (10), displaceably in the longitudinal direction thereof.

8. Contact pin assembly according to Claim 7, characterised in that the contact flexure spring (20) is placed at the second end (20a) opposite to a stop (34) which limits its displaceability in the longitudinal direction of the basic pin (10).

9. Contact pin assembly according to Claim 8, characterised in that the stop (34) is adapted to the length of the contact flexure spring and to the internal diameter of the plug socket (14) in such a way that the second end (20a) comes to abut before the contact flexure spring (20) enters with its apex into the plug socket (14).

10. Contact pin assembly according to one of Claims 1 to 9, characterised in that the contact flexure spring (20) is welded or soldered at one end with the basic pin (10).

11. Contact pin assembly according to one of Claims 1 to 10, characterised in that two contact flexure springs (20) are produced in one piece together with a connection part (28) serving for their securing on and/or electric conductive connection with the basic pin (10).

12. Contact pin assembly according to Claim 11, characterised in that the connection part (28) is made in U-form with a cross-piece (28a) which lies on a side face region (30a) of the basic pin (10) perpendicular to the long cross-sectional axis (X) of the elongated cross-seciton of the partial section (A) and with two legs (28b) which rest on the side faces (24) of the partial section (A) perpendicular to the short cross-sectional axis (Y) of the elongated cross-section of the partial section (A) and in that the contact flexure springs (20) issue from both legs (28b).

13. Contact pin assembly according to Claim 12, characterised in that the cross-piece (28a) rests on a side face region (30a) of the basic pin (10) perpendicular to the long cross-sectional axis (X) of the elongated cross-section, which side face region is set back towards the basic pin axis in relation to the pertinent side face (26) of the partial section (A) defined by the long cross-sectional axis (X).

14. Contact pin assembly according to one of Claims 12 and 13, characterised in that the cross-piece (28a) and/or at least one of the legs (28b) are soldered or welded to the side face region of the basic pin (10) abutting on each.

15. Contact pin assembly according to one of Claims 1 to 14, characterised in that the side faces (26) of the partial section (A) which are perpendicular to the long cross-sectional axis (X) of the elongated cross-section of the partial section (A), are convexly rounded towards the internal circumference of the plug socket (14).

16. Contact pin assembly according to one of Claims 1 to 15, characterised in that the side faces (126) of the partial section (A) which are perpendicular to the long cross-sectional axis (X) of the elongated cross-section, converge on one another in the insertion direction at least at their ends which lead in insertion.

17. Contact pin assembly according to one of Claims 1 to 16, characterised in that the elongated cross-section of the basic pin (10) is formed in the partial section (A) by pressing flat of a wire piece forming the basic pin (10).

18. Contact pin assembly according to Claim 17, characterised in that the wire piece (10) possesses a square cross-section and in that the axes (X, Y) of the elongated cross-section in the pressed-flat part section (A) lie in planes containing the longitudinal axis of the wire piece (10), which planes also each contain a cross-sectional axis of the square cross-section.

19. Contact pin assembly according to one of Claims 17 and 18, characterised in that the stop (34) for the contact flexure spring (20) is formed by the transition shoulder from the pressed-flat partial section (A) to an adjoining undeformed wire section (C), and on this transition shoulder (34) there may be formed a retaining nose (36) which grasps over the contact flexure spring at least after the stop (34) is reached.

20. Contact pin assembly according to one of Claims 17 to 19, characterised in that the partial section (A) comprises at least at one end a pressed-flat transition section (D) the short cross-sectional axis of which corresponds in its length to the short cross-sectional axis (Y) of the pressed-flat elongated cross-section of the partial section (A) and the long axis of which corresponds to or is smaller than the corresponding axis of the undeformed wire piece, and in that the connection part (28) rests on this transition section (D).

21. Contact pin assembly according to one of Claims 17 to 20, characterised in that the legs (28b) of the connection part (28) rest with their edges (28c) remote from the contact flexure springs (20) on transition shoulders (32) between the pressed-flat partial section (A) and an adjoining section (B) of the undeformed wire piece (10).

22. Contact pin assembly according to one of Claims 1 to 21, characterised in that the internal diameter of the plug socket (14) is smaller than 2.5 mm, especially about 1 mm.

23. Contact pin assembly according to Claim 22, characterised in that the length of the long axis (X) of the elongated cross-section is in the ratio to the length of the short axis (Y) of the elongated cross-section as 1.5 : 1-4 : 1, preferably about 2 : 1-3 : 1.

24. Contact pin assembly according to one of Claims 22 and 23, characterised in that the thickness of the leaf spring amounts to about 5/100 to about 20/100 mm.

25. Contact pin assembly according to one of Claims 1 to 21, characterised in that the ratio of the length of the partial section (A) to the internal diameter of the plug socket (14) amounts to 2 : 1 to 4 : 1, preferably about 3 : 1.

26. Contact pin assembly according to one of Claims 1 to 25, characterised in that the plug socket (14) is formed by an internally metallised hole, especially a tinned hole (18), of a circuit board (16).

27. Contact pin assembly according to one of Claims 2 to 26, characterised in that the leaf spring (220) is rounded or pointed at its free end, especially when the free end of the leaf spring (220) leads in the push-in direction.

28. Contact pin assembly according to one of Claims 7 to 27, characterised in that the first end of the contact flexure spring leads in the push-in direction.

29. Contact pin assembly according to one of Claims 1 to 27, characterised in that the second end of the contact flexure spring leads in the push-in direction.

30. Contact pin assembly according to one of Claims 3 and 4, 11 to 18 and 20 to 26, characterised in that the contact flexure spring (320), in the stressed condition and preferably also in the unstressed condition, rests with its longitudinal edge regions (320f) substantially over their entire length on the side faces (324) substantially perpendicular to the short cross-sectional axis (Y).

31. Contact pin assembly according to one of Claims 3 and 4, 11 to 18, 20 to 26 and 30, characterised in that the contact flexure spring (320) is domed (at 320g) in bath-tub form over at least a part of its length, and at least the longitudinal edge regions (320f) of the bath-tub doming (320g) rest on the side face (324) perpendicular to the short cross-sectional axis (Y) in the stressed condition and preferably also in the unstressed condition.

32. Contact pin assembly according to Claim 31, characterised in that the contact flexure spring (320) is provided on at least one end with an end flange (320h) continuing the doming (320g) of bath-tub form in the spring longitudinal direction, and in that this end flange (320h) rests on the pertinent side face (324) perpendicular to the short cross-sectional axis (Y) and may be soldered or welded with this side face.

33. Contact pin assembly according to one of Claims 3, 11 to 18, 20 to 26 and 30 to 32, characterised in that when the contact flexure spring (320) is in the unstressed condition the mean circle of curvature (320q) of the doming (320g) of the contact flexure spring (320) has its centre point (M) outside the pertinent side faces (324) substantially perpendicular to the short cross-sectional axis (Y), and has a radius (r) of curvature which is substantially smaller than half of the long cross-sectional axis (X).

34. Contact pin assembly according to Claim 33, characterised in that the distance of the centre point (M) of the mean circle (320) of curvature from the pertinent side face (324) perpendicular to the short cross-sectional axis (Y) amounts to about one-third to about two-thirds, preferably about one-half, of the radius (r) of curvature of the mean circle (320q) of curvature.

35. Contact pin assembly according to one of Claims 33 and 34, characterised in that the radius (r) of curvature of the mean circle (320q) of curvature amounts to about one-third to about two-thirds, preferably about one-half, of half of the length of the long cross-sectional axis (X).

36. Contact pin assembly according to one of Claims 33 to 35, characterised in that the inner side (320a) of the doming (320g) is of concave form in the apex region (320n) and of convex form in the edge region (320p).

37. Contact pin assembly according to Claim 36, characterised in that the contact flexure spring (320) rests with the convexly curved surface (320p) of the edge region (320f) on the side face (324) substantially perpendicular to the short cross-sectional axis (Y).

38. Contact pin assembly according to one of Claims 33 to 37, characterised in that the side faces (324) substantially perpendicular to the short cross-sectional axis (Y) are formed as plane faces or roof-shaped faces.

39. Contact pin assembly according to one of Claims 33 to 36 and 38, characterised in that the contact flexure spring (420) rests with sharp edges (420m) on the pertinent side face (324) substantially perpendicular to the short cross-sectional axis (Y).

40. Contact pin assembly according to one of Claims 33 to 37 and 39, characterised in that the side faces (424) substantially perpendicular to the short cross-sectional axis (Y) are formed as shallow channel faces.

41. Contact pin assembly according to one of Claims 33 to 40, characterised in that the outer side (320b) of the doming (320g) of the contact flexure spring (320) is convex in the apex region and is made substantially parallel to the short cross-sectional axis (Y) in the edge region (320ba).

42. Contact pin assembly according to one of Claims 3 to 41, characterised in that the material of the contact flexure spring (320) is stretch-orientated in the direction of the circumference (331) of curvature of the doming (320g).

43. Contact pin assembly according to one of Claims 17, 18, 22 to 26 and 30 to 42, characterised in that the side faces (324, 326) of the partial section (A) merge substantially smoothly into the corresponding side faces of the basic pin (310).

44. Contact pin assembly according to one of Claims 1 to 43, characterised in that the basic pin (510) is provided with a push-in contact part (555, 557) on at least one end.

45. Contact pin assembly according to one of Claims 1 to 44, characterised in that a plurality of basic pins (310) hangs together in the form of a magazine strip.

46. Contact pin assembly according to Claim 45, characterised in that the contact flexure springs (320) are formed from a sheet metal strip (317) by stamping and bending and the basic pins (310) are connected to form the magazine strip by residues of the sheet metal strip (317) which remain in the formation of the contact flexure springs (320).

47. Contact pin assembly according to one of Claims 45 and 46, characterised in that pre-set breaking points (309c, 311d, 311e) are provided between the contact flexure springs (320) and the residues of the sheet metal strip (317) which connect the basic pins (310) to form the magazine strip.

48. Contact pin assembly according to one of Claims 45 to 47, characterised in that the residues of the sheet metal strip (317) which connect the basic pins (310) to form the magazine strip are provided with guide means (313) and/or stepping means (315) for transporting the magazine strip through machining apparatuses.

49. Contact pin assembly according to one of Claims 46 to 48, characterised in that the residues of the sheet metal strip (317) which connect the basic pins (310) to form the magazine strip comprise a carrier strip (307) extending transversely of the longitudinal direction of the basic pins and parallel to the side faces (324) of the basic pins carrying the contact pin springs, on one side (324l) of the basic pins (310), and in that this carrier strip (307) is connected with contact flexure springs (320l) lying on the same side (324l) of the basic pins (310), through first connection strips (309) which lie essentially in a plane (E1) perpendicular to the longitudinal direction of the carrier strip (307) and passing through the respective basic pin (310), and/or is connected with the contact flexure springs (320k) lying on the other side (324k) of the basic pins (310) by further connection strips (311) which lie outside this plane (E1).

50. Contact pin assembly according to Claim 49, characterised in that the plane of the carrier strip (307) is substantially parallel to the longitudinal direction of the basic pins (310) and in that the first connection strip (309) comprises a first strip section (309a) substantially perpendicular to the plane of the carrier strip (307) and comprises a second strip section (309b) inclined in relation to the longitudinal direction of the respective basic pin (310), which section (309b) extends to the adjacent end of the respective contact flexure spring (320l), while a pre-set breaking point (309c) is provided at the transition from the second strip section (309b) to the contact flexure spring (320l).

51. Contact pin assembly according to Claim 49 or 50, characterised in that the second connection strip (311) comprises a repeatedly angled-off strip section (311a, 311b) which, starting from the carrier strip (307), lies in a plane (E2) substantially perpendicular to the longitudinal direction (LR) of the carrier strip (307) and laterally offset in relation to the respective basic pin (310), and a continuation strip section (311c) substantially parallel to the carrier strip (307), which connects the repeatedly angled-off strip section (311a, 311b) with the contact flexure spring (320k) lying on the other side (324k) in each case, while the plane of the carrier strip (307) is substantially parallel to the longitudinal direction of the basic pins (310), a first partial section (311a) of the repeatedly angled-off strip section (311a, 311b) adjoins the carrier strip (307) at a first angle (β) and protrudes beyond the side faces (324k) of the pertinent basic pin (310) which are remote from the carrier strip, a second partial section (311b) of the repeatedly angled-off strip section (311a, 311b) runs at a second angle (γ) in relation to the first partial section (311a) back into the plane of the side face (324k) remote from the carrier strip (310) and adjoins the continuation strip section (311c), while pre-set breaking points (311e) and (311d) are provided at the transition from the carrier strip (307) to the first partial section (311a) and/or at the transition from the continuation strip section (311c) to the respective contact flexure spring (320k).

52. Contact pin assembly according to one of Claims 49 to 51, characterised in that the carrier strip (307) is stiffened by tabs (313) angled off substantially perpendicularly to its plane, which produce a substantially U-shaped guide profile.

53. Contact pin assembly according to one of Claims 49 to 52, characterised in that the two ends of the basic pins (310) protrude in their longitudinal direction beyond the carrier strip (307) and the connection strips (309, 311).

54. Contact pin assembly according to one of Claims 1 to 53, characterised in that the contact flexure spring (620) is provided at least on its side facing the basic pin (610) with a coating (621) of good conductivity which is softer than the material of the contact flexure spring (620) and the material of the basic pin (610), for example a soft copper coating, which experiences along the edges of the contact flexure spring (620) resting on the basic pin (610) a deformation for larger area contact with the basic pin (610), when the contact flexure spring (620) is pressed against the basic pin (610).

55. Method for the production of contact flexure springs for contact pin assemblies according to one of Claims 3 to 54, characterised in that the doming (320g) is carried out, with stretch orientation of the spring material in the doming region (320g), with a direction of orientation parallel to the doming circumferential direction (331).

56. Method according to Claim 55, characterised in that in the case of production of the contact flexure springs (320) from a sheet metal strip (317), before the production of the doming (320g) in the sheet metal strip (317) slots (319) are provided in the sheet metal strip (317) with spacing from the edges of the respective contact flexure spring (320), the marginal zones (323a) of the material cross-piece (323) remaining between the slots (319) are clamped in, the middle region of this material cross-piece (323) is domed out, with formation of the stretch orientation, and then the marginal zones (323) are cut to dimension.

57. Method for the production of a contact pin assembly according to one of Claims 49 to 53 from basic pins and a sheet metal strip producing the contact flexure springs, characterised in that the sheet metal strip (317) is moved in a feed direction (LR) perpendicular to the direction of supply of the basic pins (310), in that from the sheet metal strip a filigree strip containing the contact flexure springs for the two side faces (324k, 324l) of the basic pin (310), the carrier strip (307) and the connection strips (309, 311) is obtained by stamping operations, in which filigree strip the contact flexure springs for the two side faces (324k, 324l) protrude from the carrier strip (307) in opposite directions transversely of the longitudinal direction of the carrier strip (307), in that the basic pins (310) are applied with a side face (324l) to the pertinent contact springs (320l) and may be soldered or welded once or more times therewith and thereupon the second contact flexure spring (320k) is turned over on to the other side face (324k) in each case of the basic pins (310) and may be welded or soldered once or more therewith.

58. Method for installing contact pin assemblies according to one or more of Claims 49 to 54 in a basic pin reception carrier, characterised in that firstly the second connection strips (311) are cut off and in that the first connection strips (309) are broken away after or during the introduction of the basic pins (310) into the basic pin reception carrier (349).

59. Method according to Claim 58, characterised in that the first connection strips (309) are broken away by displacement of the basic pins (310) in their longitudinal direction in relation to the carrier strip (307).

60. Circuit board with a contact pin assembly according to one of Claims 1 to 54, characterised in that the circuit board (359) is formed as a multistratum circuit board.

**Revendications**

1. Ensemble de petit format formant broche de contact électrique, destiné à être introduit dans une prise (14) de section sensiblement circulaire disposée notamment dans une plaquette de circuits imprimés, cet ensemble formant broche de contact comprenant au moins une tige de base (10 ; 210 ; 310 ; 410 ; 510 ; 610) et un ressort de contact à flexion (20 ; 220 ; 320 ; 430 ; 520 ; 620) monté sur cette tige de base, qui s'appuie sur la tige de base, est en liaison conductrice avec la tige de base et est dimensionné de manière à établir un contact électrique quand une contrainte radiale est appliquée par la périphérie interne de la prise (14), caractérisé en ce que la section transversale de la tige de base, sur au moins une section partielle (A) de sa longueur, est oblongue avec un grand axe (X) de sa section transversale dont la longueur correspond approximativement au diamètre interne de la prise (14) et avec un petit axe (Y) de sa section transversale, et en ce que le ressort de contact orienté en direction longitudinale de la tige de base (10) est disposé sur au moins une surface latérale (24 ; 224 ; 324 ; 424 ; 524 ; 624) qui est sensiblement perpendiculaire au petit axe (Y) de la section transversale, ledit ressort s'appuyant sensiblement perpendiculairement contre cette surface latérale.

2. Ensemble formant broche de contact selon la revendication 1, caractérisé en ce que le ressort de contact à flexion (20) est un ressort à lame de section oblongue, dont le grand axe de la section transversale est sensiblement parallèle au grand axe (X) de la section oblongue de la partie (A) de la tige de base (10).

3. Ensemble formant broche de contact selon la revendication 2, caractérisé en ce que le ressort de contact à flexion (20), vu en section perpendiculaire à la tige de base, est incurvé avec un côté interne (20a) de forme concave et tourné vers la tige de base (10) et un côté externe convexe (10b) tourné vers la périphérie interne de la prise (14), la ligne de sommet du côté interne de forme concave (20a) étant située à distance de la surface latérale (24) sensiblement perpendiculairement au petit axe (Y) de la section transversale et le ressort de contact s'appuyant dans la région des bords longitudinaux de son côté interne de forme concave (20a) contre la surface latérale (24) sensiblement perpendiculaire au petit axe (Y) de la section transversale.

4. Ensemble formant broche de contact selon la revendication 3, caractérisé en ce que le rayon de courbure du côté extérieur (20b) de la section du ressort à lame est légèrement inférieure et au maximum égal au rayon interne de la prise (14).

5. Ensemble formant broche de contact selon l'une des revendications 1 à 4, caractérisé en ce que le ressort de contact à flexion (20) se présente sous la forme d'un arc dans la direction longitudinale de la tige de base (10), avec une courbure concave de l'arc qui est tournée vers la partie (A) de la tige de base et une courbure convexe de l'arc qui est tournée vers la périphérie interne de la prise (14).

6. Ensemble formant broche de contact selon la revendication 5, caractérisé en ce que la surface de contact (20) est incurvée de manière qu'au moins après la réalisation de la liaison par enfichage, les deux extrémités de l'arc s'appuient en direction radiale contre partie (A) de la tige de base.

7. Ensemble formant broche de contact selon l'une des revendications 5 et 6, caractérisé en ce que le ressort de contact à flexion (20) est fixé par une première extrémité à la tige de base (10) et s'appuie de façon mobile dans sa direction longitudinale par la seconde extrémité (20a) contre la partie (A) de la tige de base (10).

8. Ensemble formant broche de contact selon la revendication 7, caractérisé en ce que le ressort de contact à flexion (20) s'appuie par la seconde extrémité (20a) contre une butée (34) qui limite sa possibilité de déplacement dans la direction longitudinale de la tige de base (10).

9. Ensemble formant broche de contact selon la revendication 8, caractérisé en ce que la butée (34) est adaptée à la longueur du ressort de contact à flexion et au diamètre interne de la prise (14) de manière que la seconde extrémité (20a) vienne en butée avant que le ressort de contact à flexion (20) pénètre par son sommet dans la prise (14).

10. Ensemble formant broche de contact selon l'une des revendications 1 à 9, caractérisé en ce que le ressort de contact à flexion (20) est soudé ou brasé à la tige de base (10) par une extrémité.

11. Ensemble formant broche de contact selon l'une des revendications 1 à 10, caractérisé en ce que deux ressorts de contact à flexion (20) sont réalisés d'un seul tenant avec une partie de raccordement (28) servant à leur fixation à et/ou à leur liaison électriquement conductrice avec la tige de base (10).

12. Ensemble formant broche de contact selon la revendication 11, caractérisé en ce que la partie de raccordement (28) est en forme de U avec une barrette (28a) s'appliquant contre une région (30a) de la surface latérale qui est perpendiculaire au grand axe (X) de la section transversale oblongue de la partie (A), et avec deux branches (28b) qui s'appliquent contre les surfaces latérales (24) de la partie (A) qui sont perpendiculaires au petit axe (Y) de la section transversale oblongue de la partie (A), et en ce que les ressorts de contact à flexion (20) partent des deux branches (28b).

13. Ensemble formant broche de contact selon la revendication 12, caractérisé en ce que la barrette (28a) repose contre une région (30a) de la surface latérale de la tige de base (10) qui est perpendiculaire au grand axe (X) de la section transversale oblongue, région qui est en retrait en direction de l'axe de la tige de base par rapport à la surface latérale associée (26) de la partie (A) définie par le grand axe (X) de la section transversale.

14. Ensemble formant broche de contact selon l'une des revendications 12 et 13, caractérisé en ce que la barrette (28a) et/ou l'une au moins des branches (28b) sont brasées ou soudées à la région de surface latérale de la tige de base (10) contre laquelle elles s'appuient.

15. Ensemble formant broche de contact selon l'une des revendications 1 à 14, caractérisé en ce que les surfaces latérales (26) de la partie (A) qui sont perpendiculaires au grand axe (X) de la section transversale oblongue de la partie (A) sont arrondies en forme convexe en direction de la périphérie interne de la prise (14).

16. Ensemble formant broche de contact selon l'une des revendications 1 à 15, caractérisé en ce que les surfaces latérales (126) de la partie (A) qui sont perpendiculaires au grand axe (X) de la section transversale oblongue convergent en direction l'une de l'autre dans le sens de l'enfoncement au moins à leur extrémité qui est à l'avant pendant l'enfoncement.

17. Ensemble formant broche de contact selon l'une des revendications 1 à 16, caractérisé en ce que la section oblongue de la tige de base (10) est constituée dans la partie (A) par compression et aplatissement d'une section d'un élément de fil formant la tige de base (10).

18. Ensemble formant broche de contact selon la revendication 17, caractérisé en ce que l'élément de fil (10) a une section carrée et en ce que les axes (X, Y) de la section oblongue sont situés, dans la partie (A) qui a été aplatie, dans des plans contenant l'axe longitudinal de l'élément de fil (10), plans qui contiennent également chacun un axe de la section carrée.

19. Ensemble formant broche de contact selon l'une des revendications 17 et 18, caractérisé en ce que la butée (34) destinée au ressort de contact à flexion (20) est constituée par l'épaulement de transition entre la partie aplatie (A) et l'élément de fil (C) non déformé qui s'y raccorde, un nez d'arrêt (36) étant également constitué au niveau de cet épaulement d'arrêt (34), qui recouvre le ressort de contact à flexion au moins lorsqu'il a atteint la butée (34).

20. Ensemble formant broche de contact selon l'une des revendications 17 à 19, caractérisé en ce que la partie (A) comprend au moins à une extrémité une partie de transition aplatie (D) dont le petit axe de la section transversale correspond par sa longueur au petit axe (Y) de la section transversale oblongue et aplatie de la partie (A) et dont le grand axe correspond à l'axe correspondant de l'élément de fil non déformé, ou est plus petit que ce dernier, et en ce que la partie de raccordement (28) s'applique contre cette partie de transition (D).

21. Ensemble formant broche de contact selon l'une des revendications 17 à 20, caractérisé en ce que les branches (28b) de la partie de raccordement (28) s'appuient par leurs bords (28c) qui sont à l'opposé des ressorts de contact à flexion (20) contre des épaulements de transition (32) entre la partie aplatie (A) et une partie (B) de l'élément de fil (10) non déformé qui s'y raccorde.

22. Ensemble formant broche de contact selon l'une des revendications 1 à 21, caractérisé en ce que le diamètre interne de la prise (14) est inférieur à 2,5 mm et est notamment d'environ 1 mm.

23. Ensemble formant broche de contact selon la revendication 22, caractérisé en ce que la longueur du grand axe (X) de la section transversale oblongue est dans un rapport avec le petit axe (Y) de la section tranversale oblongue qui est compris par exemple entre 1,5 : 1 et 4 : 1, et de préférence entre environ 2 : 1 et 3 : 1.

24. Ensemble formant broche de contact selon l'une des revendications 22 et 23, caractérisé en ce que l'épaisseur du ressort à lame est comprise entre environ 5/100 et environ 20/100 de mm.

25. Ensemble formant broche de contact selon l'une des revendications 1 à 21, caractérisé en ce que le rapport entre la longueur de la partie (A) et le diamètre interne de la prise (14) est compris entre 2 : 1 et 4 : 1 et est de préférence d'environ 3 : 1.

26. Ensemble formant broche de contact selon l'une des revendications 1 à 25, caractérisé en ce que la prise (14) est formée par un trou à métallisation interne et notamment par un trou étamé (18) d'une plaquette à circuits imprimés (16).

27. Ensemble formant broche de contact selon l'une des revendications 2 à 26, caractérisé en ce que le ressort à lame (220) est arrondi ou émoussé à son extrémité libre, notamment si l'extrémité libre du ressort à lame (220) est à l'avant dans la direction de l'enfoncement.

28. Ensemble formant broche de contact selon l'une des revendications 7 à 27, caractérisé en ce que la première extrémité du ressort de contact à flexion est disposée dans la direction de l'enfoncement.

29. Ensemble formant broche de contact selon l'une des revendications 1 à 27, caractérisé en ce que la seconde extrémité du ressort de contact à flexion est disposée dans la direction de l'enfoncement.

30. Ensemble formant broche de contact selon l'une des revendications 3 et 4, 11 à 18 et 20 à 26, caractérisé en ce que le ressort de contact à flexion (320) s'applique à l'état tendu et de préférence également à l'état détendu par ses régions de bords longitudinales (320f) et de préférence sur la totalité de sa longueur contre les surfaces latérales (324) qui sont sensiblement perpendiculaires au petit axe (Y) de la section transversale.

31. Ensemble formant broche de contact selon l'une des revendications 3 et 4, 11 à 18, 20 à 26 et 30, caractérisé en ce que le ressort de contact à flexion (320) est recourbé sous la forme d'une cuvette (en 320 g) au moins sur une partie de sa longueur, les régions (320f) des bords longitudinaux de la courbure en forme de cuvette (320g) s'appliquant à l'état tendu et de préférence également à l'état détendu contre la surface latérale (324) qui est perpendiculaire au petit axe (Y) de la section transversale.

32. Ensemble formant broche de contact selon la revendication 31, caractérisé en ce que le ressort de contact à flexion (320) est muni à au moins une extrémité d'un flasque d'extrémité (320h) qui prolonge dans la direction longitudinale du ressort la partie bombée en forme de cuvette (320g), et en ce que ce flasque d'extrémité (320h) s'applique contre la surface latérale associée (324) qui est perpendiculaire au petit axe (Y) de la section transversale, et est éventuellement brasé ou soudé à celle-ci.

33. Ensemble formant broche de contact selon l'une des revendications 3, 11 à 18, 20 à 26 et 30 à 32, caractérisé en ce qu'à l'état tendu du ressort de contact à flexion (320), le cercle de courbure central (320q) de la partie bombée (320) du ressort de contact à flexion (320) a son centre (M) à l'extérieur de la surface latérale associée (324) qui est sensiblement perpendiculaire au petit axe (Y) de la section transversale, et présente un rayon de courbure (r) qui est sensiblement plus petit que la moitié du grand axe (X) de la section transversale.

34. Ensemble formant broche de contact selon la revendication 33, caractérisé en ce que la distance entre le centre (M) du cercle de courbure central (320) et la surface latérale associée (324) qui est perpendiculaire au petit axe (Y) de la section transversale est comprise entre environ un tiers et environ deux tiers, et est de préférence d'environ la moitié, du rayon de courbure (r) du cercle de courbure central (320q).

35. Ensemble formant broche de contact selon l'une des revendications 33 et 34, caractérisé en ce que le rayon de courbure (r) du cercle de courbure central (320q) est compris entre environ un tiers et environ les deux tiers, et est de préférence la moitié, de la longueur du grand axe (X) de la section transversale.

36. Ensemble formant broche de contact selon l'une des revendications 33 à 35, caractérisé en ce que le côté interne (320a) de la partie bombée (320g) est de forme concave dans la région de sommet (320n) et de forme convexe dans la région des bords (320p).

37. Ensemble formant broche de contact selon la revendication 36, caractérisé en ce que le ressort de contact à flexion (320) repose par la surface de courbure convexe (320p) de la région de bord (320f) contre la surface latérale (324) qui est sensiblement perpendiculaire au petit axe (Y) de la section transversale.

38. Ensemble formant broche de contact selon l'une des revendications 33 à 37, caractérisé en ce que les surfaces latérales (324) qui sont sensiblement perpendiculaires au petit axe (Y) de la section transversale sont réalisés sous forme de surfaces planes ou de surfaces en forme de toits.

39. Ensemble formant broche de contact selon l'une des revendications 33 à 36 et 38, caractérisé en ce que le ressort de contact à flexion (420) repose par des arêtes aiguës (420m) contre la surface latérale associée (424) qui est sensiblement perpendiculaire au petit axe (Y) de la section transversale.

40. Ensemble formant broche de contact selon l'une des revendications 33 à 37 et 39, caractérisé en ce que les surfaces latérales (424) qui sont sensiblement perpendiculaires au petit axe (Y) de la section transversale sont réalisées sous forme de surfaces en forme de rigoles plates.

41. Ensemble formant broche de contact selon l'une des revendications 33 à 40, caractérisé en ce que le côté extérieur (320b) de la partie bombée (320g) du ressort de contact à flexion (320) est de forme convexe dans la région du sommet et est sensiblement parallèle au petit axe (Y) de la section transversale dans la région de bord (320ba).

42. Ensemble formant broche de contact selon l'une des revendications 3 à 41, caractérisé en ce que le matériau du ressort de contact à flexion (320) est orienté par étirage en direction de la périphérie (331) de la courbure de la partie bombée (320g).

43. Ensemble formant broche de contact selon l'une des revendications 17, 18, 22 à 26 et 30 à 42, caractérisé en ce que les surfaces latérales (324, 326) de la partie (A) se prolongent de façon sensiblement continue par les surfaces latérales correspondantes de la tige de base (310).

44. Ensemble formant broche de contact selon l'une des revendications 1 à 43, caractérisé en ce que la tige de base (510) est munie à au moins une extrémité d'une pièce de contact à enfichage (555, 557).

45. Ensemble formant broche de contact selon l'une des revendications 1 à 44, caractérisé en ce qu'une pluralité de tiges de base (310) sont réunies sous la forme d'une bande magasin.

46. Ensemble formant broche de contact selon la revendication 45, caractérisé en ce que les ressorts de contact à flexion (320) sont réalisés par estampage et flexion à partir d'une bande de tôle (317) et les tiges de base (310) sont reliées à la bande magasin au moyen des restes de la bande de tôle (317) qui subsistent après la formation des ressorts de contact à flexion (320).

47. Ensemble formant broche de contact selon les revendications 45 et 46, caractérisé en ce que des zones de rupture imposées (309c, 311d, 311e) sont prévues entre les ressorts de contact à flexion (320) et les parties restantes de la bande de tôle (317) reliant les tiges de base (310) à la bande magasin.

48. Ensemble formant broche de contact selon l'une des revendications 45 à 47, caractérisé en ce que les parties restantes de la bande de tôle (317) qui relient les tiges de base (310) à la bande magasin sont munies de moyens de guidage (313) et/ou de moyens d'avance (315) en vue du transport de la bande magasin par des dispositifs de traitement.

49. Ensemble formant broche de contact selon l'une des revendications 46 à 48, caractérisé en ce que les parties restantes de la bande de tôle (317) reliant les tiges de base (310) à la bande magasin comprennent sur un côté (324l) des tiges de base (310) une bande porteuse (307) qui est transversale à la direction longitudinale des tiges de base et parallèle aux ressorts d'enfichage à contact et en ce que cette bande porteuse (307) est reliée aux ressorts de contact à flexion (320l) situés sur le même côté (324l) des tiges de base (310) par des premières bandes de liaison (309) qui sont disposées dans un plan (E1) sensiblement perpendiculaire à la direction longitudinale de la bande porteuse (307) et passant par la tige de base respective (310) et/ou est reliée par d'autres bandes de liaison (311) aux ressorts de contact par flexion (320k) qui sont situés sur l'autre côté (324k) des tiges de base (310), ces bandes étant situées en dehors de ce plan (E1).

50. Ensemble formant broche de contact selon la revendication 49, caractérisé en ce que le plan de la bande porteuse (307) est sensiblement parallèle à la direction longitudinale des tiges de base (310) et en ce que la première bande de liaison (309) comprend une première section de bande (309a) sensiblement perpendiculaire au plan de la bande porteuse (307) et une seconde section de bande (309b) inclinée par rapport à la direction longitudinale de la tige de base respective (310), qui se raccorde à l'extrémité voisine du ressort de contact à flexion respectif (320l), une zone de rupture imposée (309c) étant prévue à la transition entre la seconde section de bande (309b) et le ressort de contact à flexion (320l).

51. Ensemble formant broche de contact selon la revendication 49 ou 50, caractérisé en ce que la seconde bande de liaison (311) comprend une section de bande plusieurs fois coudée (311a, 311b) qui, partant de la bande porteuse (307), est disposée dans un plan (E2) décalé latéralement par rapport à la tige de base respective (310) et sensiblement perpendiculaire à la direction longitudinale (LR) de la bande porteuse (307) et relie une section de bande de prolongement (311c) sensiblement parallèle à la bande porteuse (307), qui relie la section de bande plusieurs fois coudée (311a, 311b) au ressort de contact à flexion (320k) situé sur le côté opposé respectif (324k), le plan de la bande porteuse (307) étant sensiblement parallèle à la direction longitudinale des tiges de base (310), une première section partielle (311a) de la section de bande plusieurs fois coudée (311a, 311b) se raccorde à la bande porteuse (307) en formant un premier angle β et fait saillie de la surface latérale (324k) de la tige de base associée (310) qui est à l'opposé de la bande porteuse, une seconde section partielle (311b) de la section de bande plusieurs fois coudée (311a, 311b) revient en formant un second angle α avec la première section partielle (311a) dans le plan de la surface latérale (324k) qui est à l'opposé de la bande porteuse (310) et se raccorde à la section de bande de prolongement (311c), des positions de rupture de consigne (311e ou 311d) étant prévues à la transition entre la bande porteuse (307) et la première section partielle (311a) et/ou à la transition entre la section de bande de transition (311c) et le ressort de contact à flexion respectif (320k).

52. Ensemble formant broche de contact selon l'une des revendications 49 à 51, caractérisé en ce que la bande porteuse (307) est renforcée par des pattes (313) coudées sensiblement à angle droit par rapport à son plan, déterminant un profil de guidage sensiblement en forme de U.

53. Ensemble formant broche de contact selon l'une des revendications 49 à 52, caractérisé en ce que les deux extrémités de la tige de base (310) dépassent, dans la direction longitudinale, la bande porteuse (307) et les bandes de liaison (309, 311).

54. Ensemble formant broche de contact selon l'une des revendications 1 à 53, caractérisé en ce que le ressort de contact à flexion (620) est muni au moins sur son côté qui est tourné vers la tige de base (610) d'une couche (621) de bonne conductivité et plus molle que le matériau du ressort de contact à flexion (620) et que le matériau de la tige de base (610), par exemple une couche de cuivre mou, qui subit le long des bords du ressort de contact à flexion (620) qui s'appliquent contre la tige de base (610) une déformation en vue de s'appliquer par une surface plus importante contre la tige de base (610) quand le ressort de contact à flexion (620) est pressé contre la tige de base (610).

55. Procédé pour réaliser les ressorts de contact à flexion d'ensembles formant broches de contact selon l'une des revendications 3 à 54, caractérisé en ce qu'on réalise la partie bombée (320g) par un étirage orienté du matériau du ressort dans la région de la partie bombée (320g) avec une direction d'orientation qui est parallèle à la direction périphérique (331) de la partie bombée.

56. Procédé selon la revendication 55, caractérisé en ce que lors de la réalisation des ressorts de contact à flexion (320) à partir d'une bande de tôle (317) et avant la réalisation de la partie bombée (320g) dans la bande de tôle (317) on prévoit à distance des bords du ressort de contact à flexion respectif (320) des fentes (319) dans la bande de tôle (317), on serre les régions de bord (320a) de la partie de matériau (323) qui subsiste entre les fentes (319), on provoque le bombement de la partie centrale de cette partie de matériau (323) par application de l'étirage orienté et on sectionne les régions de bord (323a).

57. Procédé pour réaliser un ensemble formant broche de contact selon l'une des revendications 49 à 53, constitué par des tiges de base et une bande de tôle permettant d'obtenir des ressorts de contact à flexion, caractérisé en ce que la bande de tôle (317) est déplacée dans une direction d'avance (LR) perpendiculairement à la direction d'alimentation des tiges de base (310), en ce que l'on obtient de la bande de tôle et par des opérations d'estampage une bande filigranée contenant les ressorts de contact à flexion pour les deux surfaces latérales (324k, 324l) de la tige de base (310), la bande porteuse (307) et les bandes de liaison (309, 311), bande filigranée dans laquelle les ressorts de contact à flexion font saillie des deux surfaces latérales (324k, 324l) de la bande porteuse (307) en direction contraire et transversalement à la direction longitudinale de la bande porteuse (307), en ce que les tiges de base (310) sont appliquées par une surface latérale (324l) contre les ressorts de contact associés (320l) et éventuellement brasées ou soudées une ou plusieurs fois à ceux-ci et ensuite le second ressort de contact à flexion (320a) est rabattu sur l'autre surface latérale (324k) de la tige de base (310) et est éventuellement soudé ou brasé plusieurs fois sur celle-ci.

58. Procédé pour incorporer des ensembles formant broches de contact selon l'une des revendications 49 à 54 dans un support récepteur de tiges de base, caractérisé en ce que les secondes bandes de liaison (311) sont préalablement sectionnées et en ce que les premières bandes de liaison (309) sont cassées après ou pendant l'introduction des tiges de base (310) dans le support récepteur de tiges de base (349).

59. Procédé selon la revendication 58, caractérisé en ce que les premières bandes de liaison (309) sont rompues par déplacement des tiges de base (310) dans leur direction longitudinale par rapport à la bande porteuse (307).

60. Plaquette à circuits imprimés comprenant un ensemble formant broche de contact selon l'une des revendications 1 à 54, caractérisée en ce que la plaquette à circuits imprimés (359) est constituée sous forme d'une plaquette multicouches.

FIG.1

FIG.2

FIG.7

FIG.8

0 101 782

FIG . 3

FIG . 4

FIG . 5

FIG . 6

# FIG. 9

# FIG. 10

# FIG . 11

FIG. 12

0 101 782

FIG. 13

# FIG. 14

# FIG.15

# FIG.17

# FIG.16

# FIG.18C

# FIG.18

# FIG.18 B

320 k

313

311

307

313

311

320k

309

315

313

315

309

313

320l

320 l

FIG.18A

# FIG.19    FIG.20

# FIG. 21

# FIG.22

# FIG. 23

# FIG.24

320g  333  320g  327  323a  331  320g  323  323a

323a  319  323a  319  325  329  319  321  317

16  LR  320ba  320m

0 101 782

# FIG. 25

# FIG. 28

# FIG.26

# FIG.27

# FIG. 29

≈ 1 : 200

621

621

620

610

1mm ⌀

621

621

620